# EUROPEAN PATENT SPECIFICATION

(11) **EP 3 701 273 B1**
(45) Date of publication and mention of the grant of the patent: **26.03.2025**
(21) Application number: 18804758.3
(22) Date of filing: 25.10.2018
(51) Int. Cl.: G01R 1/04

(54) **BALANCED CONFORMING FORCE MECHANISM FOR INTEGRATED CIRCUIT PACKAGE WORKPRESS TESTING SYSTEMS**
MECHANISMUS MIT AUSGEGLICHENER ANPASSUNGSKRAFT FÜR EIN ARBEITSPRESSENPRÜFSYSTEM FÜR INTEGRIERTE SCHALTKREISEINHEITEN
MÉCANISME DE FORCE DE CONFORMATION ÉQUILIBRÉE POUR SYSTÈMES DE TEST DE PRESSE DE TRAVAIL DE BOÎTIER DE CIRCUIT INTÉGRÉ

(30) Priority: 26.10.2017 US 201715794479; 02.11.2017 US 201715802251; 02.11.2017 US 201715802253
(43) Date of publication of application: 02.09.2020
(73) Proprietor: Xilinx, Inc., San Jose, California 95124 (US)
(72) Inventor: MARDI, Mohsen, H., San Jose, CA 95124 (US); MAHONEY, David, M., San Jose, CA 95124 (US)
(74) Representative: Zimmermann & Partner Patentanwälte mbB
(86) International application number: PCT/US2018/057586
(87) International publication number: WO 2019/084318

(56) References cited:
- US-A- 6 025 732
- US-A1- 2003 032 326
- US-A1- 2006 068 614
- US-A1- 2007 096 760
- US-A1- 2007 269 999
- US-A1- 2009 015 279
- US-A1- 2014 333 338
- US-A1- 2017 059 611

## Description

### TECHNICAL FIELD

Embodiments of the present disclosure generally relate to an automated test system having a workpress configured to conform to a top surface of a device under test, and non-conductive pusher pins for use in the same.

### BACKGROUND

Electronic devices, such as tablets, computers, copiers, digital cameras, smart phones, control systems and automated teller machines, among others, often employ electronic components which leverage integrated circuit (e.g., chip) package assemblies for increased functionality and higher component density. Chip package assemblies include one or more integrated circuit dice mounted on a package substrate.

Prior to incorporation into an electronic device, chip packages are tested to ensure that the performance of the chip packages meet predefined performance criteria. In most conventional automatic test equipment utilized to test chip packages, some type of clamp or actuator is utilized to force the chip package into a test socket that electrically couples the circuitry of the chip package with test circuitry of the automatic test equipment. The actuator of the automatic test equipment is typically coupled to a first end of a workpress. The workpress may be any interface utilized to push or drive a device under test (DUT) or other workpiece against the test socket or other supporting surface A second end of the workpress has a surface specifically designed to engage the top surface of the chip package while pressing the chip package into the test socket. The actuator is configured to move the workpress to apply a force to the top of the chip package, thus urging the chip package into the test socket. Because second surface of the workpress contacting the chip package is typically machined out of aluminum, workpress may not apply force as designed to the chip package due to height differences within the chip package, such as for example differences in height between stiffeners, lids, package substrates and the like. The nonuniform application of force results in some regions of the chip package receiving too much force while other regions not receiving enough force to ensure good electrical connection between the chip package and test socket. Undesirably, this may lead to damage and poor testing of the chip package. The challenges of applying force as intended increases dramatically in lid-less chip package designs where differences in the heights of tightly spaced dice may vary significantly.

Therefore, a need exists for an improved test system and method for testing integrated circuit packages, along with non-conductive pusher pins for use in the same.

Document US 2006/068614 A1 describes an integrated circuit (IC) package socket device that can receive two or more IC packages and the method of operating the device. Uses for the device include burn-in in which testing and programming of dies or completed IC packages. The device can also be arranged to receive two or more types of IC packages. A pressure unit is tiltably attached to the lid of the socket device providing a resilient normal force to each of the two or more IC packages without damaging the IC packages. The pressure unit has two or more pressure pads that correspondingly apply the resilient normal force to each of the two or more IC packages. The IC packages are received in recesses where the recesses are typically arranged in an array with the pressure pads in the pressure unit arranged so as to align with the array of recesses.

Document US 2007/096760 A1 describes a method for testing a semiconductor structure having a set of top-side connections and having a set of bottom-side connections is provided. The method may include providing a device socket for connecting the set of top-side connections and the set of bottom-side connections to a tester. The method may further include providing a device hood for connecting the set of top-side connections to a respective first end of each of a plurality of interconnects in the device hood, wherein a second end of each of the plurality of interconnects in the device hood connects the set of top-side connections to the device socket. The method may further include testing the semiconductor structure using the tester. The semiconductor structure may include at least one integrated circuit to be tested.

Document US 6025732 A describes a reusable carrier for temporarily holding an integrated circuit during burn-in and electrical test includes a base and a lid attached to the base by hinges. A flexible substrate is attached to the base. Alignment posts have tapered surfaces that engage corners of the integrated circuit to position the integrated circuit precisely on upper surface of the substrate. A spring-loaded latch engages projection in aperture of the base to hold the lid closed over the integrated circuit. Electrically conductive traces on the surface have contact bumps which engage contact pads on the underside of the integrated circuit to connect the integrated circuit to peripheral contact pads around edges of the substrate. A spring engages upper surface of the integrated circuit when the lid is in its closed position over the integrated circuit, to provide a biasing force to urge the contact pads against the conductive traces with sufficient force to insure a reliable electrical connection. For burn-in, the temporary package containing the integrated circuit die is now loaded into a socket on a burn-in board, which is then loaded into a burn-in system, where otherwise standard burn-in is performed.

Document JP 2011/257239A describes an electric characteristic inspection apparatus and an electric characteristic inspection method capable of applying a uniform load to an object to be inspected and reducing an inspection time. An electrical property inspection apparatus sucks and holds an object to be inspected from a direction pressed by the pressing mechanism and a pressing mechanism that presses the object to be inspected with the same pressing force at a plurality of points. And a transport mechanism for transporting. Document JP 2005/283417 A describes a uniform pressing force is applied to a surface of a semiconductor device on which an external terminal is provided without being affected by vertical thickness variations in the semiconductor device. A contact pusher is lowered, and a plurality of pogo pins attached to a lower portion of the contact pusher, and an external terminal of a semiconductor device 105 and a pogo pin which is a contactor for electrically connecting a test substrate. Is pushed to an appropriate load (about 10 kg) at which electrical contact can be made between the external terminal of the semiconductor device and the tip of the pogo pin as a contact. Due to this pushing, the thickness variation on the upper surface of the semiconductor device is absorbed by the plurality of pogo pins attached to the lower part of the contact pusher, and a uniform pressing force is applied in the vertical direction to the upper surface of the semiconductor device.

### SUMMARY

According to an embodiment of the invention, an integrated circuit chip package test system according to claim 1 is provided.

An integrated chip package assembly test system and method for testing a chip package assembly are described herein. In one example, an integrated circuit chip package test system includes a socket and a workpress. The socket is configured to receive a chip package assembly for testing in the test system. The workpress is positioned over the socket and has a bottom surface that is dynamically conformable to a multi-planar top surface topography of the chip package assembly.

In another example, a method for testing a chip package is provided. The method includes moving a bottom surface of a workpress against a multi-planar top surface topography of a chip package assembly disposed in a socket of an automated test system; dynamically conforming the bottom surface of the workpress to the multi-planar top surface topography of the chip package assembly as the workpress moves towards the socket; and testing the chip package utilizing signals transmitted through the socket to the chip package assembly.

In another example, an integrated circuit chip package test system includes a socket and a workpress, wherein the socket is configured to receive a chip package assembly for testing in the test system. The workpress includes a plurality of pusher pins. The plurality of pusher pins have tips extending from a bottom surface of the workpress. Each of the plurality of pusher pins is configured to apply an independent and discrete force to the chip package assembly disposed in the socket.

In another example, a method for testing a chip package is provided that includes: moving a bottom of a workpress against a multi-planar top surface topography of a chip package assembly disposed in a socket of a test system; independently applying localized force to the multi-planar top surface topography of the chip package assembly as the workpress moves towards the socket; and testing the chip package utilizing signals transmitted through the socket to the chip package assembly.

Others examples of the present disclosure relate to a pusher pin having an electrically non-conductive portion for use in an automated test assembly. In one example, an electrically insulative pusher pin includes a first plunger member, a second plunger member, and a spring. The first plunger member has a first end and an exposed second end. The second plunger member has a first end and an exposed second end. The second plunger member is movable relative to the first plunger member, where the exposed second ends of the first and second plunger members defining a length of the pusher pin. The spring disposed between the first ends of the first and second plunger members and biases the exposed second end of the first plunger member away from the exposed second end of the second plunger member. An electrically insulative path is defined between the exposed second end of the first plunger member and the exposed second end of the second plunger member through the pusher pin.

In another example, an integrated circuit package test assembly that employs at least one electrically insulative pusher pin is disclosed. The integrated circuit package test assembly includes a workpress, a socket and an actuator. The workpress has a top end and a bottom end. The bottom end of the workpress has a first plurality of pusher pins. The socket has a top end facing the bottom end of the workpress. The top end of the socket has a second plurality of pusher pins. The actuator is configured to move the workpress towards the socket a sufficient distance to cause the first plurality of pins and the second plurality of pins to engage a DUT when disposed in the socket. At least a first pusher pin of the first plurality of pusher pins or at least one pusher pin of the second plurality of pusher pins has an open circuit defined between opposite ends of the first pusher pin.

In another example, a method of testing an integrated circuit package in an integrated circuit package test assembly. The method includes contacting a DUT with at least a first non-conductive pusher pin on a top surface or a bottom surface of the DUT, contacting the DUT with at least a first conductive pusher pin on the top surface or the bottom surface of the DUT, and testing the DUT in contact with the first non-conductive pusher pin and the first conductive pusher pin though signals provided through the first conductive pusher pin.

In another example, the method of testing described above may be implemented with a non-conductive pusher pin which is fabricated as an assembled compliant plunger, a stamped or formed plunger, a slider plunger, an H-slider pin, a spring pin, a buckling pin, a cobra pin, a pogo-pin, a microelectromechanical (MEMS) pin or other workpiece pusher suitable for contacting surfaces of a lid-less chip package.

In another example, the method of testing described above may be implemented with a non-conductive pusher pin which has a unitary construction that incorporates a spring form. That is, the non-conductive pusher pin is made from a single mass of material to provide the unitary construction. For example, the unitary construction may be achieved through stamping, machining, MEMS fabrication techniques, 3D printing or other suitable technique.

In another example, the method of testing described above may be implemented with a non-conductive pusher pin which incorporates a compressible, resilient material that allows the pusher pin to change length. The compressible, resilient material may be a foam, an elastomer, plastic spheres or other suitable material.

### BRIEF DESCRIPTION OF THE DRAWINGS

So that the manner in which the above recited features of the present disclosure can be understood in detail, a more particular description of the disclosure, briefly summarized above, may be had by reference to embodiments, some of which are illustrated in the appended drawings. It is to be noted, however, that the appended drawings illustrate only typical embodiments of this disclosure and are therefore not to be considered limiting of its scope, for the implementation of the disclosure may admit to other equally effective embodiments.

The scale of the figures, including the relative scale of items depicted within a single figure, are not to scale for the purpose of clarity of explanation due to the small size and tight spacing of the actual components.
Figure 1A is a schematic side view of a chip package assembly test system having a workpress that dynamically conforms to a top surface of a device under test.
Figure 1B is a schematic side view of a chip package assembly test system having a workpress assembly disposed in an open position that is clear of a socket of the test system.
Figure 1C is a schematic side view of the chip package assembly test system of Figure 1A having the workpress assembly disposed in a closed position that places the workpress assembly over and adjacent to the socket of the test system.
Figures 2-6 are bottom views of a workpress of the chip package assembly test system of Figures 1A-1C having various distributions of pusher pins, according to various embodiments.
Figures 7-10 are schematic partial side views of various configurations of the workpress of Figures 1A-1C, according to various embodiments.
Figures 11-13 illustrate various workpresses engaging a chip package assembly disposed in the automated test system of Figures 1A-1C, according to various embodiments.
Figure 14 is a side view of an exemplary pusher pin, according to an embodiment.
Figure 15 is a side view of an exemplary pusher pin having an external spring, according to an embodiment.
Figure 16 is a side view of an exemplary pusher pin having a slide mechanism coupling the plunger members of the pusher pin, according to an embodiment.
Figures 17-18 are side and front views of an exemplary pusher pin having an external spring, according to an embodiment.
Figure 19 is a sectional view of an exemplary pusher pin having a spring fabricated from a compressible material, according to an embodiment.
Figure 20 is a side view of an exemplary pusher pin having a unitary construction that incorporates a spring form, according to an embodiment.
Figure 21 is a side view of a workpress of the chip package assembly test system of Figures 1A-1C having a temperature control block.
Figure 22 is a side view of a workpress of the chip package assembly test system of Figures 1A-1C having a temperature control block with integrated pusher pins.
Figure 23 is a flow diagram of a method for testing a chip package assembly.
Figure 24 shows a perspective of an exemplary pusher pin, according to an embodiment.
Figure 25 shows a perspective of an exemplary pusher pin having an electrically insulative tip, according to an embodiment.
Figure 26 shows a perspective of an exemplary pusher pin having an electrically insulative tip, according to an embodiment.
Figure 27 shows a perspective of an exemplary pusher pin having an electrically insulative first plunger member, according to an embodiment.
Figure 28 shows a perspective of an exemplary pusher pin having an electrically insulative second plunger member, according to an embodiment.
Figure 29 shows a perspective of an exemplary pusher pin having an electrically insulative shell, according to an embodiment.
Figure 30 shows a front elevation of a portion of a first plunger member of an exemplary pusher pin illustrating an electrically insulative portion of the first plunger member, according to an embodiment.
Figure 31 shows a schematic block diagram of an integrated circuit package test assembly that employs at least one of the pusher pins of Figures 24-31.
Figure 31A shows one example of an enlarged portion of a chip package in contact with the pusher pins of Figures 24-31 while disposed in an integrated circuit package test assembly.
Figure 32 is a process flow of a method of testing an integrated circuit package in an integrated circuit package test assembly, according to an embodiment.
Figure 33 shows a side view of an exemplary pusher pin having an external spring, according to an embodiment.
Figure 34 shows a side view of an exemplary pusher pin having a slide mechanism coupling the plunger members of the pusher pin, according to an embodiment.
Figures 35-36 show side and front views of an exemplary pusher pin having an external spring, according to an embodiment.
Figure 37 shows a sectional view of an exemplary pusher pin having a spring fabricated from a compressible material, according to an embodiment.
Figure 38 shows a side view of an exemplary pusher pin having a unitary construction that incorporates a spring form, according to an embodiment.

To facilitate understanding, identical reference numerals have been used, where possible, to designate identical elements that are common to the figures. It is contemplated that elements of one embodiment may be beneficially incorporated in other embodiments.

### DETAILED DESCRIPTION

A chip package assembly test system and method for testing chip package assemblies disclosed herein that advantageously reduce the potential of damage to devices under test (DUT). The chip package assembly test system incorporates a workpress having a bottom surface that dynamically conformed to the topography of the DUT. The workpress may be any interface utilized to push or drive the DUT or other workpiece against a supporting surface, such as a test socket of the test system. The dynamically conforming workpress additionally contact the DUT with a plurality of individual separate and distinct pusher pins that can be configured to apply a localized force to selected portions of the DUT. Moreover, since the force can be distributed across the DUT as needed to ensure robust electrical connection between the DUT and test system, the locally applied force may be much smaller as compared with the force applied utilizing conventional systems, thereby significantly reducing the potential damage to the DUT. It is also contemplated that the workpiece supporting surface may also be configured with a dynamically conforming surface that supports the DUT with a plurality of individual separate and distinct pusher pins that can be configured to apply a localized force to selected portions of the DUT. It is further contemplated that the DUT may be a wafer when performing wafer level testing, or other object to be tested that would benefit from being secured in a test system utilizing dynamically conforming DUT contacting and/or supporting surfaces. These and other advantages are described below.

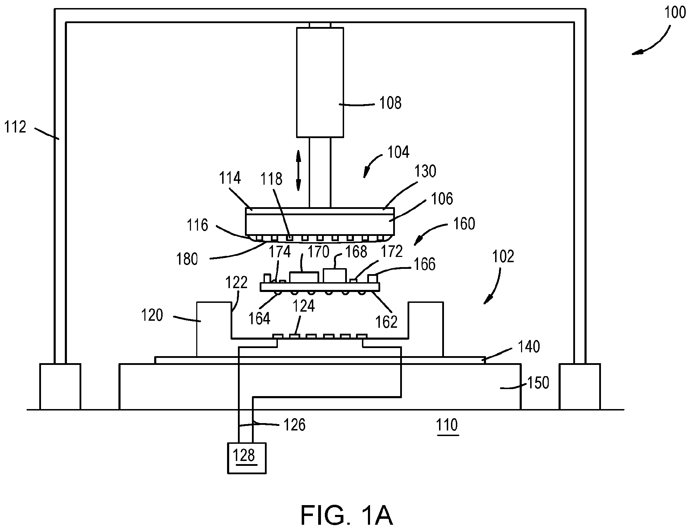

Figure 1A is a schematic side view of a chip package assembly test system 100 having a workpress 106 that dynamically conforms to a top surface of a DUT. The DUT is generally described herein as a chip package assembly 160, although the workpress 106 and or test system 100 may be adapted for use with other workpieces. Prior to describing the test system 100 in greater detail, an exemplary chip package assembly 160 will be described below. However, the specific configuration of the chip package assembly 160 described below is just for purposes of illustration, and other variations of chip package assemblies may be tested utilizing the test system 100 described herein.

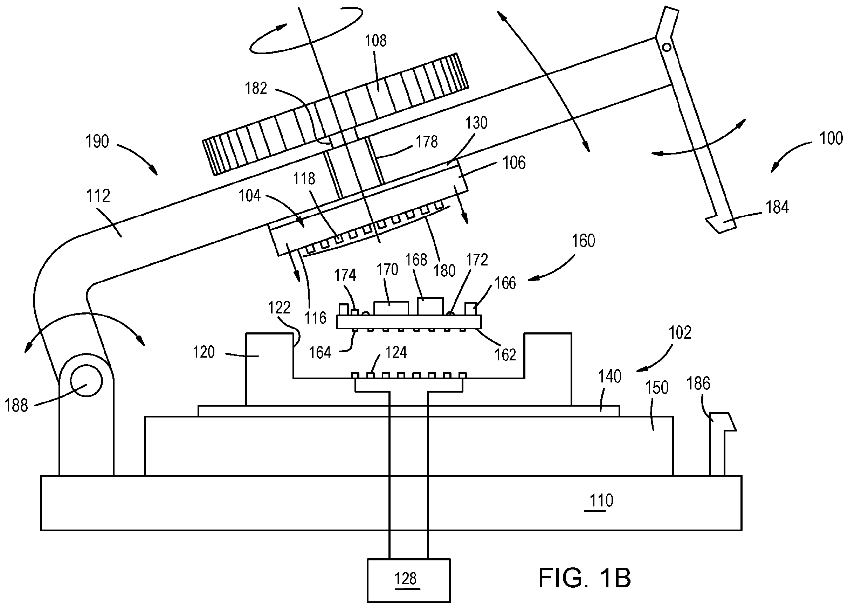

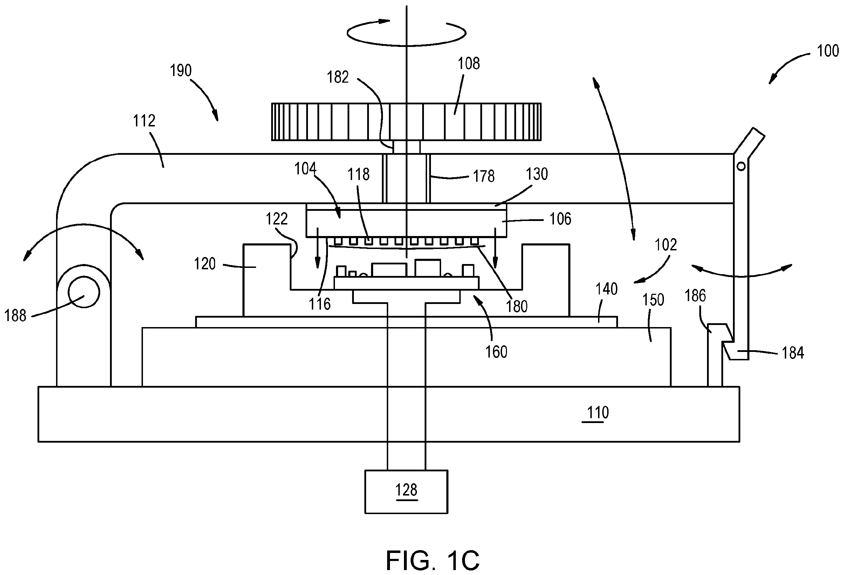

The chip package assembly 160, ball grid array (BGA) packages as a non-limiting example, generally includes at least one or more integrated circuit (IC) dice disposed on a package substrate 162. In the example depicted in Figure 1, two dice 168, 170 are shown with the die 168 extending higher above the package substrate 162 relative to the die 170. In some embodiments, an interposer (not shown) may be utilized to provide improved interconnection between the IC dice 168, 170, and the package substrate 162. The IC dice 168, 170 may be a programmable logic device, such as field programmable gate arrays (FPGA), a memory device, an optical device, a MEMS device, a processor or other IC logic or memory structure. Optical devices include photodetectors, lasers, optical sources, and the like. Solder bumps (i.e., electrical connections) 164 are disposed on a bottom surface of the package substrate 162 to facility electrical communication of power, ground and signals to the circuitry of the dice 168, 170 mounted to the package substrate 162. The functionality of the dice 168, 170 are provided by solid state circuitry formed in the dice 168, 170. At the end of the chip package assembly fabrication process, the chip package assemblies 160 are tested to ensure robust and predictable performance.

The chip package assembly 160 may also include one or more of the following components: a stiffener 166, one or more surface mounted circuit elements 172, and one or more test pads 174. The stiffener 166 is fabricated from a rigid material and is attached to the package substrate 162 near the perimeter of the package substrate 162. The stiffener 166 circumscribes the dice 168, 170 and functions to minimize warpage of the package substrate 162.

The surface mounted circuit elements 172 are mounted to the package substrate 162. The surface mounted circuit elements 172 may be a passive circuit component, such as resistors, capacitors, diodes, inductors and the like. The surface mounted circuit elements 172 are electrically connected to circuitry routed within or on the package substrate 162

The test pads 174 are mounted to the package substrate 162. The test pads 174 are utilized to provide ground, power or signals to one or more of the dice 168, 170 during testing of the chip package assembly 160. Advantageously, the test pads 174 may be utilized to communicate with one or more of the dice 168, 170 during testing without having to utilize a dedicated contact pad of the test system 100 interfaced with one of the solder bumps 164 formed on the bottom of the package substrate 162.

Although not shown, the chip package assembly 160 may optionally include one or more of a cover mounted to the stiffener, heat sinks, and overmolding. As stated above, the configuration of the chip package assembly 160 shown in Figure 1 is for illustration, and chip package assemblies having different configurations may also be tested utilizing the test system 100.

Turning now to the chip package assembly test system 100, the test system 100 includes at least one test station 102, a workpress assembly 104, a base 110 and a test controller 128. The test station 102 and the workpress assembly 104 are coupled to the base 110.

The test station 102 includes a mother board 150 that is mounted to the base 110. A daughter board 140 is coupled to the mother board 150. The daughter board 140 has one or more test sockets 120. Only a single test socket 120 is illustrated in Figure 1 for simplicity. The test socket 120 generally includes a recess 122 configured to receive the chip package assembly 160 to be tested by the test system 100. The recess 122 includes exposed contact pads 124 that are coupled by routing 126 running through the mother and daughter boards 150, 140 to the controller 128 to facilitate electric communication between the controller 128 and the chip package assembly 160 during testing.

The workpress assembly 104 is supported by a support 112 above the test station 102. The support 112 is coupled to the base 110. The support 112 may be a stanchion or gentry, and supports the workpress assembly 104 over the test station 102. The workpress assembly 104 is configured to urge and engage the chip package assembly 160 with the socket 120 of test station 102 for testing as further described below.

The workpress assembly 104 includes a workpress 106, a mounting plate 130 and an actuator 108. The workpress 106 has a bottom surface 116 facing the socket 120 and a top surface. The top surface of the workpress 106 is coupled by the mounting plate 130 to the actuator 108. The actuator 108 couples the mounting plate 130 to the support 112. The actuator 108 is operable to move the workpress 106 towards and away from the socket 120. In one example, the actuator 108 is coupled to the test controller 128 and automatically moves the workpress 106 in response to instructions from the test controller 128. The actuator 108 is configured to push the chip package assembly 160 disposed against a bottom (shown by a dashed line 180) of the workpress 106 into the socket 120 with sufficient force to ensure robust electrical contact between the solder bumps 164 of chip package assembly 160 and contact pads 124 formed in the recess 122 of the socket 120 to facilitate effective communication of power, ground and signals that facilitate testing of the chip package assembly 160. The actuator 108, such as a pneumatic cylinder, ball screw, or other linear actuator, that can control the force exerted by the workpress 106 that pushes the chip package assembly 160 against the socket 120. In one example, the actuator 108 is operable to urge the workpress 106 downward against the chip package assembly 160 with a force of about 35 grams per solder bump 164.

As discussed above, the contact pads 124 of the test station 102 are coupled to the test controller 128. The test controller 128 generally executes test routine (e.g., predetermined test routine) that is stored in or accessible by the test controller 128. The test routine may be inputted into the test controller 128 through a user interface, or uploaded or accessed from the test controller 128 and/or host processing system (not shown). The test controller 128 executes the test routine in a manner that runs a predefined test on the chip package assembly 160 disposed in the socket 120 of the test station 102. The test routine may be one or more of a DC test routine, a burn-in routine, post burn-in routine, a final test routine or other predefined test routine to be performed on the chip package assembly 160.

In one example, a DC test routine is performed on chip package assembly 160 disposed in the socket 120 of the test station 102. The DC test routine may include subjecting the chip package assembly 160 to a high DC load for a period to time, and testing the chip package assembly 160 for electrical shorting, resistance, temperature rise, RC delay, speed, other performance characteristic or malfunction or other defect.

In another example, a burn-in test routine is performed on chip package assembly 160 disposed in the socket 120 of the test station 102. The burn-in test routine may include subjecting the chip package assembly 160 to a high-stress environment, such as high voltage, high amperage, high temperature and/or high frequency electric signals. The burn-in test routine may include subjecting the chip package assembly 160 to a high-stress environment for a period to time, and testing the chip package assembly 160 for a short, resistance, temperature rise, RC delay, speed, other performance characteristic or malfunction or other defect.

In yet another example, a post burn-in test routine is performed on chip package assembly 160 disposed in the test station 102. The post burn-in test routine may include testing the electrical characteristics and function of the chip package assembly 160 at room temperature and below room temperature. The post burn-in test routine may include subjecting the chip package assembly 160 to a room temperature environment for a period to time, and testing the electrical characteristics and function of the chip package assembly 160. The post burn-in test routine may also include subjecting the chip package assembly 160 to a sub-room temperature environment for a period to time, and testing the electrical characteristics and function of the chip package assembly 160. The post burn-in test routine may include determining test information, such as performance, functionality, pass, fail or other performance information associated with the tested chip package assembly 160. Other performance may include, but is not limited to, one or more of resistance, temperature rise, RC delay, speed, malfunction or other defect

In still yet another example, a final test routine is performed on chip package assembly 160 disposed in the test station 102. The final test routine may include testing the electrical characteristics and function of the chip package assembly 160 at a temperature elevated above room temperature (e.g., elevated temperature such as at about 155 degrees Celsius) and/or at a temperature below room temperature (e.g., cold temperature such as at about -55 degrees Celsius). The final test routine may include subjecting the chip package assembly 160 to an elevated (and/or cold) temperature environment for a period to time, and testing the electrical characteristics and function of the chip package assembly 160. The final test routine may include determining test information, such as performance, functionality, pass, fail or other performance information, to the information stored on the test controller 128 and uniquely associated with the tested chip package assembly 160.

In yet another example, the final test routine performed on chip package assembly 160 may mimic operating conditions of the device in which the chip package assembly 160 will be interfaced with. The operating conditions of the final test routine may include temperature variation and voltage fluctuations. It is contemplated that other test routines may be performed in the test station 102 or other test station within the test system 100.

Since chip package assemblies 160 having different designs often have different patterns for solder bumps 164 formed on the bottom surface of the package substrate 162 that do not match the pattern of contact pads 124 disposed in the bottom of the socket 120, the daughter board 140 may be easily replaced with another daughter board 140 having a replacement socket 120 that is configured to mate with the next chip package assembly 160 to be tested in the test system 100.

As discussed briefly above, the bottom 180 of the workpress 106 is configured to dynamically conform to a top surface of the chip package assembly 160. In one example to achieve this result, the bottom 180 of the workpress 106 includes a plurality of projecting pusher pins 118. The pusher pins 118 function as a "bed of nails" which apply force to plurality of individually separate and distinct locations of the chip package assembly 160. In this manner, the localized force may be much less than a force spread across the entire chip package assembly 160 as done in conventional test systems. The local reduction in force advantageously reduces the potential of damage to the chip package assembly 160. In one example, each pusher pin 118 is operable to urge the chip package assembly 160 into the socket 120 with a force of about a force of between about 0.15 to 1.00 newtons (N) at about half the stroke of the pusher pin 118. Moreover, the locations of each pusher pin 118, along with the force generated by each pusher pin 118 when contacting the chip package assembly 160, may be selected so as to not damage the components of the chip package assembly 160. Additionally, the pusher pins 118 are advantageously non-conductive between the ends of the pusher pins 118 such that the pusher pins 118 do not inadvertently short components of the chip package assembly 160 while under test.

Figure 1B is a schematic side view of a chip package assembly test system 100 having a workpress assembly 104 that includes a plurality of discrete and independent force applicators configured to apply localized force to discrete locations of a DUT. The DUT is generally described herein as a chip package assembly 160, although the workpress assembly 104 and or test system 100 may be adapted for use with other workpieces. Figure 1B depicts the workpress assembly 104 in an open positon clear of a socket 120 of the test system 100 in which the chip package assembly 160 is held during testing. In the open position, the chip package assembly 160 may be freely placed in and removed from the socket 120.

Prior to describing the test system 100 in greater detail, an exemplary chip package assembly 160 will be described below. However, the specific configuration of the chip package assembly 160 described below is just for purposes of illustration, and other variations of chip package assemblies may be tested utilizing the test system 100 described herein.

The chip package assembly 160, ball grid array (BGA) packages as a non-limiting example, generally includes at least one or more integrated circuit (IC) dice disposed on a package substrate 162. In the example depicted in Figure 1, two dice 168, 170 are shown with the die 168 extending higher above the package substrate 162 relative to the die 170. In some embodiments, an interposer (not shown) may be utilized to provide improved interconnection between the IC dice 168, 170, and the package substrate 162. The IC dice 168, 170 may be a programmable logic device, such as field programmable gate arrays (FPGA), a memory device, an optical device, a MEMS device, a processor or other IC logic or memory structure. Optical devices include photodetectors, lasers, optical sources, and the like. Electrical connections 164, such as solder balls, solder bumps, contact pads and the like, are disposed on a bottom surface of the package substrate 162 to facility electrical communication of power, ground and signals to the circuitry of the dice 168, 170 mounted to the package substrate 162. The functionality of the dice 168, 170 are provided by solid state circuitry formed in the dice 168, 170. At the end of the chip package assembly fabrication process, the chip package assemblies 160 are tested to ensure robust and predictable performance.

The chip package assembly 160 may also include one or more of the following components: a stiffener 166, one or more surface mounted circuit elements 172, and one or more test pads 174. The stiffener 166 is fabricated from a rigid material and is attached to the package substrate 162 near the perimeter of the package substrate 162. The stiffener 166 circumscribes the dice 168, 170 and functions to minimize warpage of the package substrate 162.

The surface mounted circuit elements 172 are mounted to the package substrate 162. The surface mounted circuit elements 172 may be a passive circuit component, such as resistors, capacitors, diodes, inductors and the like. The surface mounted circuit elements 172 are electrically connected to circuitry routed within or on the package substrate 162

The test pads 174 are mounted to the package substrate 162. The test pads 174 are utilized to provide ground, power or signals to one or more of the dice 168, 170 during testing of the chip package assembly 160. Advantageously, the test pads 174 may be utilized to communicate with one or more of the dice 168, 170 during testing without having to utilize a dedicated contact pad of the test system 100 interfaced with one of the electrical connections 164 formed on the bottom of the package substrate 162.

Although not shown, the chip package assembly 160 may optionally include one or more of a cover mounted to the stiffener, heat sinks, and overmolding. As stated above, the configuration of the chip package assembly 160 shown in Figure 1 is for illustration, and chip package assemblies having different configurations may also be tested utilizing the test system 100.

Turning now to the chip package assembly test system 100, the test system 100 includes at least one test station 102, the workpress assembly 104, a base 110, a cover assembly 190 and a test controller 128. The test station 102 is coupled to the base 110. The workpress assembly 104 is coupled to the cover assembly 190. The cover assembly 190 is movably coupled to the base 110, for example, by a hinge 188. It is contemplated that the cover assembly 190 may be movably coupled to the base 110 utilizing other devices, such as a gantry, press or other suitable device. The cover assembly 190 may be moved between an open position that places the workpress assembly 104 clear of the socket 120, as shown in Figure 1B, and a closed position that places the workpress assembly 104 immediately above the socket 120, as shown in Figure 1C. In the closed position, the workpress assembly 104 is in a position to engage the chip package assembly 160 with the socket 120 of the test station 102.

The test station 102 includes a mother board 150 that is mounted to the base 110. A daughter board 140 is coupled to the mother board 150. The daughter board 140 has one or more test sockets 120. Only a single test socket 120 is illustrated in Figures 1A-1C for simplicity. The test socket 120 generally includes a recess 122 configured to receive the chip package assembly 160 to be tested by the test system 100. The recess 122 includes exposed contact pads 124 that are coupled by routing 126 running through the mother and daughter boards 150, 140 to the controller 128 to facilitate electric communication between the controller 128 and the chip package assembly 160 during testing.

As discussed above, the cover assembly 190 movably supports the workpress assembly 104 above the test station 102. The cover assembly 190 includes a support 112 that is coupled to the base 110. The support 112 may be coupled to the test station 102 by a hinge 188 or other device that facilitates movement of the workpress assembly 104 between the positions adjacent and clear of the socket 120. In the open positon, the workpress assembly 104 is positioned to allow the chip package assembly 160 to be placed in or removed from the socket 120 of test station 102. In the closed position, the workpress assembly 104 is configured to engage and drive the chip package assembly 160 into the socket 120 of test station 102 for testing as further described below.

The cover assembly 190 includes an actuator 108 and an optional latch 184. The latch 184 is operable to engage a catch 186 coupled to the base 110. When the latch 184 and catch 186 are engaged when the cover assembly 190 is in the closed position, the workpress assembly 104 secured directly over and adjacent the socket 120.

The workpress assembly 104 includes a workpress 106 and a mounting plate 130. The workpress 106 has a bottom surface 116 facing the socket 120 and a top surface 114. The top surface 114 of the workpress 106 is coupled to the mounting plate 130. The actuator 108 couples the mounting plate 130 to the support 112 of the cover assembly 190. The actuator 108 is operable to move the workpress 106 towards and away from the socket 120. In one example, the actuator 108 includes a knob or lever coupled to a threaded member 182. The threaded member 182 is coupled to the mounting plate 130. The threaded member 182 engages a threaded hole 178 formed in the support 112. By rotation of the knob, the threaded member 182 is advanced through threaded hole 178, thus moving the mounting plate 130 and workpress 106 in a direction normal to the socket 120, as illustrated in Figure 1C. Alternatively, the actuator 108 may be a cam, lever, linkage, air cylinder, motor, or other device suitable to advance the workpress 106 in a manner that pushes the chip package assembly 160 disposed against a bottom (shown by a dashed line 180 illustrated in Figure 1B) of the workpress 106 normally towards the socket 120 with sufficient force to ensure robust electrical contact between the electrical connections 164 of chip package assembly 160 and contact pads 124 formed in the recess 122 of the socket 120 to facilitate effective communication of power, ground and signals that facilitate testing of the chip package assembly 160. The actuator 108, such as a pneumatic cylinder, ball screw, or other linear actuator, that can control the force exerted by the workpress 106 that pushes the chip package assembly 160 against the socket 120. In one example, the actuator 108 is operable to urge the workpress 106 downward against the chip package assembly 160 with a force of about 35 grams per electrical connection 164.

As discussed above, the contact pads 124 of the test station 102 are coupled to the test controller 128. The test controller 128 generally executes test routine (e.g., predetermined test routine) that is stored in or accessible by the test controller 128. The test routine may be inputted into the test controller 128 through a user interface, or uploaded or accessed from the test controller 128 and/or host processing system (not shown). The test controller 128 executes the test routine in a manner that runs a predefined test on the chip package assembly 160 disposed in the socket 120 of the test station 102. The test routine may be one or more of a DC test routine, a burn-in routine, post burn-in routine, a final test routine or other predefined test routine to be performed on the chip package assembly 160.

In one example, a DC test routine is performed on chip package assembly 160 disposed in the socket 120 of the test station 102. The DC test routine may include subjecting the chip package assembly 160 to a high DC load for a period to time, and testing the chip package assembly 160 for electrical shorting, resistance, temperature rise, RC delay, speed, other performance characteristic or malfunction or other defect.

In another example, a burn-in test routine is performed on chip package assembly 160 disposed in the socket 120 of the test station 102. The burn-in test routine may include subjecting the chip package assembly 160 to a high-stress environment, such as high voltage, high amperage, high temperature and/or high frequency electric signals. The burn-in test routine may include subjecting the chip package assembly 160 to a high-stress environment for a period to time, and testing the chip package assembly 160 for a short, resistance, temperature rise, RC delay, speed, other performance characteristic or malfunction or other defect.

In yet another example, a post burn-in test routine is performed on chip package assembly 160 disposed in the test station 102. The post burn-in test routine may include testing the electrical characteristics and function of the chip package assembly 160 at room temperature and below room temperature. The post burn-in test routine may include subjecting the chip package assembly 160 to a room temperature environment for a period to time, and testing the electrical characteristics and function of the chip package assembly 160. The post burn-in test routine may also include subjecting the chip package assembly 160 to a sub-room temperature environment for a period to time, and testing the electrical characteristics and function of the chip package assembly 160. The post burn-in test routine may include determining test information, such as performance, functionality, pass, fail or other performance information associated with the tested chip package assembly 160. Other performance may include, but is not limited to, one or more of resistance, temperature rise, RC delay, speed, malfunction or other defect

In still yet another example, a final test routine is performed on chip package assembly 160 disposed in the test station 102. The final test routine may include testing the electrical characteristics and function of the chip package assembly 160 at a temperature elevated above room temperature (e.g., elevated temperature such as at about 155 degrees Celsius) and/or at a temperature below room temperature (*e.g.*, cold temperature such as at about -55 degrees Celsius). The final test routine may include subjecting the chip package assembly 160 to an elevated (and/or cold) temperature environment for a period to time, and testing the electrical characteristics and function of the chip package assembly 160. The final test routine may include determining test information, such as performance, functionality, pass, fail or other performance information, to the information stored on the test controller 128 and uniquely associated with the tested chip package assembly 160.

In yet another example, the final test routine performed on chip package assembly 160 may mimic operating conditions of the device in which the chip package assembly 160 will be interfaced with. The operating conditions of the final test routine may include temperature variation and voltage fluctuations. It is contemplated that other test routines may be performed in the test station 102 or other test station within the test system 100.

Since chip package assemblies 160 having different designs often have different patterns for electrical connections 164 formed on the bottom surface of the package substrate 162 that do not match the pattern of contact pads 124 disposed in the bottom of the socket 120, the daughter board 140 may be easily replaced with another daughter board 140 having a replacement socket 120 that is configured to mate with the next chip package assembly 160 to be tested in the test system 100.

As discussed briefly above, the bottom 180 of the workpress 106 is configured with a plurality of discrete and independent force applicators that apply localized force at discrete locations to a top surface of the chip package assembly 160. In one example to achieve this result, the bottom 180 of the workpress 106 includes a plurality of discrete and independent force applicators. The force applicators may be springs, actuators, elastomer projections or other suitable element that generates a resilient force upon deflection or displacement. In one non-limiting example, the force applicators are a plurality of pusher pins 118 projecting from the bottom surface 116 of the workpress 106. The pusher pins 118 function as a "bed of nails" which apply force to plurality of individually separate and distinct locations of the chip package assembly 160. In this manner, the distributed force may be much less than a force localized around the perimeter of the chip package assembly 160 as done in conventional test systems. The local reduction in force advantageously reduces the potential of damage to the chip package assembly 160. In one example, each pusher pin 118 is operable to urge the chip package assembly 160 into the socket 120 with a force of about a force of between about 0.15 to 1.00 newtons (N) at about half the stroke of the pusher pin 118. Moreover, the locations of each pusher pin 118, along with the force generated by each pusher pin 118 when contacting the chip package assembly 160, may be selected so as to not damage the components of the chip package assembly 160. Additionally, the pusher pins 118 are advantageously non-conductive between the ends of the pusher pins 118 such that the pusher pins 118 do not inadvertently short components of the chip package assembly 160 while under test.

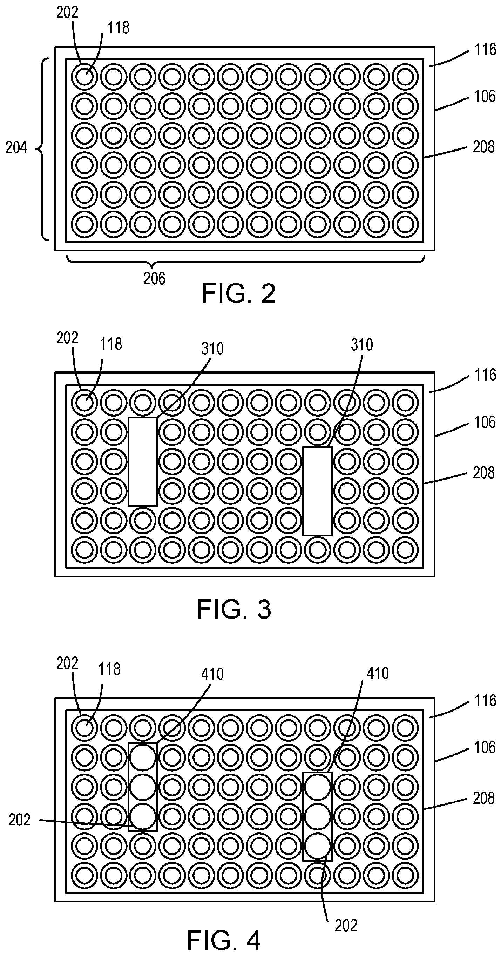

Figures 2-6 are bottom views of the workpress 106 of the chip package assembly test system 100 of Figures 1A-1C having various distributions of pusher pins 118, according to different embodiments. Referring first to Figure 2, the pusher pins 118 are illustrated extending through a plurality of pusher pin holes 202 formed through the bottom surface 116 of the workpress 106. Each pusher pin 118 resides in a corresponding one of the holes 202. The holes 202 may be arranged in an array, have a non-regular pattern, a grid pattern or other pattern suitable for advantageously distributing force to the top surface of the chip package assembly 160.

In the example depicted in Figure 2, the holes 202 are arranged in N rows 204 and M columns 206, where N and M are positive integers. The 6 rows 204 and 12 columns 206 of holes 202 are merely for illustrative purposes, and any number N, M of holes 202 comprising the rows 204 and columns 206 may be chosen in response to the topography of the chip package assembly 160 to be tested and the force desired to be distributed across that topography.

In the example depicted in Figure 2, the rows 204 and columns 206 are arranged in a Cartesian grid, the extents of which form a boundary 208. The boundary 208 is illustrated by a dashed line. Within the boundary 208, the rows 204 and columns 206 are uniformly distributed in both the row and column directions.

Figure 3 depicts a bottom view of the workpress 106 of the chip package assembly test system 100 with a distribution of pusher pins 118 different than that of Figure 2. The workpress 106 illustrated in Figure 3 includes one or more depleted areas 310 defined within the boundary 208. The depleted area 310 defined on the bottom surface 116 of the workpress 106 is devoid of pusher pin holes 202. Stated differently, no holes 202 are formed in the bottom surface 116 of the workpress 106 within the depleted area 310. Since there are no holes 202 disposed in the depleted area 310, there are also no pusher pins 118 in the depleted area 310. Since there are no pusher pins 118 disposed in the depleted area 310, consequently no force is applied to the chip package assembly 160 below the depleted area 310. The depleted area 310 may be located over regions of the chip package assembly 160 in which it would be undesirable to contact with the pusher pin 118.

Each depleted area 310 encompasses an area that would have been utilized at least one hole 202. In the example illustrated in Figure 3, the depleted area 310 encompasses an area that would have been utilized by three rows of holes 202 when arranged in a single column. Alternatively, the depleted area 310 may have another shape, included by not limited to a ring shape, a rectangular shape, and a single point, among others.

Figure 4 depicts a bottom view of the workpress 106 of the chip package assembly test system 100 with a distribution of pusher pins 118 different than that of Figure 2. Similar to Figure 3, the workpress 106 illustrated in Figure 4 includes one or more depleted areas 410 defined within the boundary 208. In the depleted area 410, there are no pusher pins 118 disposed in the holes 202 are formed in the bottom surface 116 of the workpress 106. Consequently, no force is applied to the chip package assembly 160 below the depleted area 410. The depleted area 410 may be located over regions of the chip package assembly 160 in which it would be undesirable to contact with the pusher pin 118. The depleted area 410 may be located as desired on the bottom surface 116 of the workpress 106 as described above with reference to the depleted area 310.

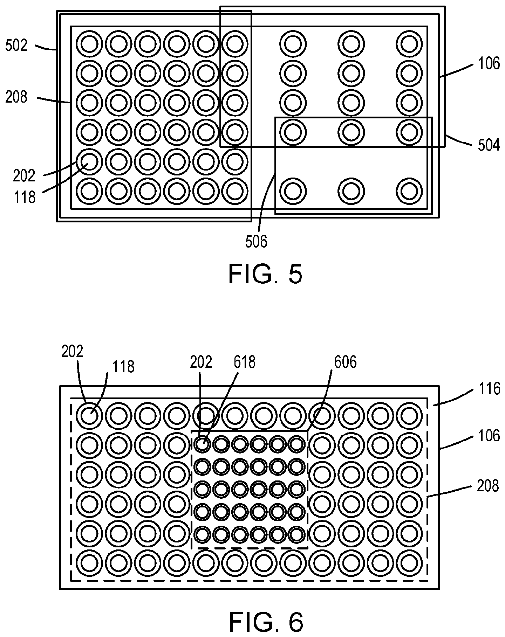

Figure 5 depicts a bottom view of the workpress 106 of the chip package assembly test system 100 with a distribution of pusher pins 118 different than that of Figures 2-4. In the example illustrated in Figure 5, the pusher pins 118 disposed within the boundary 208 are grouped in at least two regions of different pusher pin density.

For example, a first region 502 includes a first group of pusher pins 118 disposed within the boundary 208 having a common pitch that is the same in at least one direction (*i.e.*, at least one of a row or column). In the example illustrated in Figure 5, the first group of pusher pins 118 disposed in the first region 502 have a common pitch in both the rows and columns.

A second region 504 includes a second group of pusher pins 118 disposed within the boundary 208 that have a common pitch that is the different in one direction as compared to the first group of pins 118 disposed in the first region 502. Stated differently, the second group of pusher pins 118 disposed in the second region 504 have a pitch in common with the first group of pusher pins 118 of the first region 502 in only one of a row or a column. In the example illustrated in Figure 5, the second group of pusher pins 118 disposed in the second region 504 have a pitch in common with the first group of pusher pins 118 of the first region 502 only in the rows of holes 202 and pusher pins 118, while the pitch defining the columns of holes 202 of the first group of pusher pins 118 in the first region 502 is different than that of the second group of pusher pins 118 disposed in the second region 504.

Also depicted in Figure 3, a third region 506 includes a third group of pusher pins 118 disposed within the boundary 208 having a pitch that is the different in both directions as compared to the first group of pins 118 disposed in the first region 502. Stated differently, the third group of pusher pins 118 disposed in the third region 506 have a different pitch compared with the first group of pusher pins 118 of the first region 502 in both the rows and columns.

Figure 6 depicts a bottom view of the workpress 106 of the chip package assembly test system 100 with a distribution of pusher pins different than that of Figures 2-5. In the example illustrated in Figure 5, the pusher pins disposed within the boundary 208 are grouped in at least two regions of different sizes. The pusher pins comprising each of the two regions may be arranged in different densities or the same density.

For example, a region 606 includes at least one or more pusher pins 618 disposed within the boundary 208 that have a size different that is different than that of at least one or more pusher pins 118 disposed within the boundary 208. In the example illustrated in Figure 6, the pusher pins 618 disposed in the region 606 are smaller than the pusher pins 118. The pusher pins 618 generally have the same functionality as the pusher pins 118, and may be constructed similarly as described below. Although the pusher pins 618 are grouped in a common rectangular region, the pusher pins 618 may be arranged in any manner. For example, the pusher pins 618 may be arranged in rows, rings, columns, in a grid, or as otherwise desired. In another example, one or more pusher pins 618 may be surrounded by a plurality of pusher pins 118.

It is additionally contemplated that the pusher pins 118 (and pins 618) may be arranged in two or more of the combinations described with reference to Figures 2-6 or other suitable manner. For example, the workpress 106 with one or more depleted areas 310 may also have one or more depleted areas 410, regions of different densities (such as two or more of the regions 502, 504 and/or 506), and regions of different size pusher pins (such as at least two regions comprising one or more pusher pins 118, 618). Similarly, the workpress 106 regions of different densities (such as two or more of the regions 502, 504 and/or 506) may also have regions of different size pusher pins (such as at least two regions comprising one or more pusher pins 118, 618). In this manner, the amount of force and location to which the force is applied to the top surface of the chip package assembly 160 may be easily configured for just about any topography of the chip package assembly 160 while robustly ensuring good electric connection with the socket 120 and with minimal risk of damage to the chip package assembly 160.

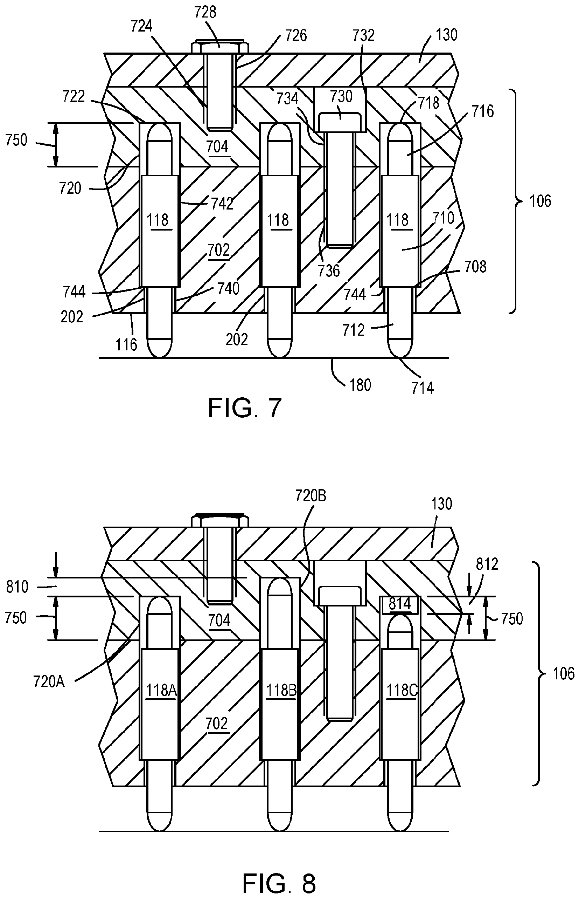

Figure 7 is a schematic side view of the workpress 106 of Figure 1. The workpress 106 may be secured to the mounting plate 130 in any suitable manner that allows one workpress to be readily interchanged with another workpress as needed when switching between testing chip package assemblies 160 having different configurations. In the example depicted in Figure 7, the workpress 106 may be secured to the mounting plate 130 utilizing a fastener 728 that extends through a clearance hole 726 formed in the mounting plate 130 and engages a threaded hole 724 formed in the workpress 106.

The workpress 106 is generally fabricated from aluminum or other sufficiently rigid and dimensionally stable material. The workpress 106 be fabricated as a unitary structure, or fabricated in multiple sections that are coupled together. In the example depicted in Figure 7, the workpress 106 includes at least a first section 702 and a second section 704 that captures the pusher pins 118 within the workpress 106. A top surface of the first section 702 defines a top surface of the workpress 106. A bottom surface of the second section 704 defines the bottom surface 116 of the workpress 106. The first section 702 may be secured to the second section 704 in any suitable manner that allows the pusher pins 118 to be replaced if needed. For example, the first section 702 may be secured to the second section 704 utilizing a fastener 730 that extends through a clearance hole 734 formed in the first section 702 and engages a threaded hole 736 formed in the second section 704. The clearance hole 734 may also include a counterbore 732 to recess the head of the fasteners 730 below the top surface of the first section 702, thus allowing the first section 702 to be mounted flush against the mounting plate 130.

The pusher pin holes 202 formed through the bottom surface 116 of the workpress 106 and extend through the first sections 702 and at least a portion of the second section 704. The orientation of the pusher pin holes 202 is generally normal to the bottom surface 116 of the workpress 106.

The portion of the pusher pin hole 202 formed through the first section 702 of the workpress 106 includes a first diameter section 740 and a second diameter section 742. The first diameter section 740 exits the first section 702 at the bottom surface 116. The first diameter section 740 has a diameter that is less than a diameter of the second diameter section 742. The transition between the first and second diameter sections 742, 740 forms a step 744. The step 744 is sized to prevent the entire pusher pin 118 from passing completely out of the workpress 106 through the bottom surface 116, as further described below. With the pusher pins 118 installed in the workpress 106, a tip 714 of the pusher pin 118 extends beyond the bottom surface 116 of the workpress 106 by a sufficient amount to allow the pusher pin 118 to engage the chip package assembly 160 and have sufficient travel to apply the desired amount of force to the top surface of the chip package assembly 160. As shown by the dashed line in Figure 7, the tips 714 of the pusher pins 118 define the bottom 180 of the workpress 106. As the tips 714 of each pusher pin 118 may move independently and separately from the other pusher pins 118, the discrete independent movement and force generation of the pusher pins 118 distributed across the bottom 180 of the workpress 106 enable the bottom 180 to dynamically conform to the topography of the chip package assembly 160 as the workpress 106 is advanced towards the socket 120.

The portion of the pusher pin hole 202 formed through the second section 704 of the workpress 106 includes a hole 720. The hole 720 may be a blind hole having a bottom 722, or may alternatively be formed completely through the second section 704 such that the mounting plate 130 forms the bottom 722 of the hole 720. The bottom 722 of the hole 720 extends a depth 750 from a bottom surface of the second section 704 of the workpress 106. The depth 750, along with the spring constant of the pusher pin 118, is generally selected to set the force that the pusher pin 118 will exert on the chip package assembly 160. Thus, the force generated by each pusher pin 118 disposed in the workpress 106 is controlled by selecting the parameters of the depth 750 of the hole 720, along with the spring constant and the length of the each pusher pin 118. These parameters may be selected so that all the pusher pins 118 exert a uniform force per unit displacement, or that at least one or all of the pusher pins 118 exert different forces per unit displacement.

When the sections 702, 704 are assembled, the second diameter section 742 of the pusher pin hole 202 formed through the first section 702 aligns with the hole 720 to allow the pusher pin 118 to be captured within the hole 202. The sections 702, 704 may readily be disassembled by removing the fastener 730 to allow replacement of damaged pusher pins 118, or to replace one or more pusher pins 118 with pins 118 having a different spring force. In this manner, different ones of the pusher pins 118 may apply different forces to local areas of the top of the chip package assembly 160.

The pusher pin 118 shown disposed in the hole 202 includes a first plunger 712, a case 710, and a second plunger 716. The case 710 generally has a diameter greater than that of the plungers 712, 716, but less than that of the second diameter section 742 of the portion of the pusher pin hole 202 formed through the first section 702 of the workpress 106. The first plunger 712 has a diameter selected to travel freely within the first diameter section 740 the pusher pin hole 202. The case 710 includes a shoulder 708 defined between the outside diameter of the case 710 and the first plunger 712. The shoulder 708 contacts the step 744 so that the case 710 of the pusher pin 118 is prevented from passing completely out the bottom surface 116 of the workpress 106 through the first diameter section 740 of the pusher pin hole 202.

Figure 8 is a schematic side view of another embodiment the workpress 106 of Figures 1A-1C configured to provide different forces to local areas of the top of the chip package assembly 160. The workpress 106 depicted in Figure 8 is constructed essentially the same as the workpress 106 depicted in Figure 7, except wherein at least one or more holes 720 formed in the second section 704 is configured to change the effective depth of the hole 720, thereby adjusting the force applied by the pusher pin 118 disposed in that hole 720. For example, one hole 720 may have a depth 750 while another one of the holes 720 may have a depth that is different by an amount 810. Although the amount 810 illustrated in Figure 8 indicates that the hole 720_{B} is deeper than the hole 720₄, the hole 720_{B} may alternatively be shallower than the hole 720₄. Thus, in the example depicted in Figure 8, the force generated by identical pusher pins 118_{A}, 118_{B} respectively disposed in holes 720_{A}, 720_{B} will result in the pusher pin 118_{A} applying more force to the chip package assembly 160 relative to the pusher pin 118_{B}. The difference in force may further be tailored (*e.g.*, selected) by utilizing pusher pins 118_{A}, 118_{B} that have at least one of stoke or spring constant different than the other pin.

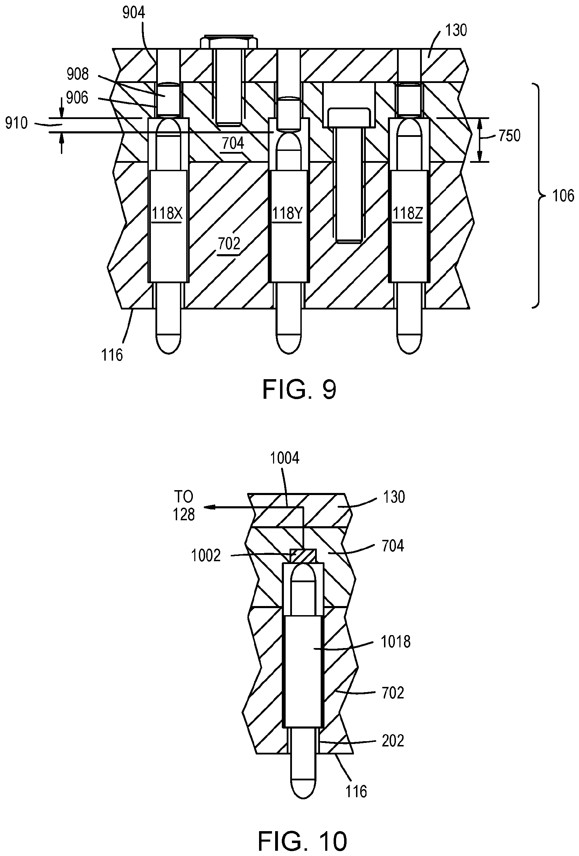

The effective depth of the hole 720 may also be changed by inserting a spacer 814 within the hole 720, as depicted in the partial sectional view of the workpress 106 illustrated in Figure 9. The spacer 814 reduces the depth 750 of the hole 720 by a thickness 812 of the spacer 814. Thus, the force generated by identical pusher pins 118_{A}, 118_{C} disposed in holes 720 having the same depth 750 will result in the pusher pin 118_{C} applying more force to the chip package assembly 160 relative to the pusher pin 118_{A}.

The effective depth of the hole 720 may also be changed by protruding an object through the bottom 722 of the hole 720 as depicted in the partial sectional view of the workpress 106 illustrated in Figure 10. In Figure 10, a set screw 908 is shown engaged with a threaded hole 906 formed in the second section 704 of the workpress 106. The threaded hole 906 opens into the hole 720. The set screw 908 disposed within the threaded hole 906 may be access through a clearance hole 904 formed through mounting plate 130, thereby allowing adjustment of the set screw 908 after the workpress 106 has been secured to the mounting plate 130. The set screw 908 may be advanced into the hole 720 a distance 910, and compresses the pusher pin 118_{Y} more than the pusher pins 118_{X}, 118_{Z} residing in the holes 720 having the same depth 750. The set screw 908 reduces the effective depth (*i.e.*, depth 750 less the distance 910) of the hole 720 by the distance 910 that the set screw 908 extends into the hole 720. Thus, the force generated by identical pusher pins 118_{Y}, 118_{Z} will result in the pusher pin 118_{Y} applying more force to the chip package assembly 160 relative to the pusher pin 118_{Z}.

Although a set screw 908 is illustrated in Figure 9 as the object protruding into the hole 720, other objects that may be utilized in place of the set screw 908 include other threaded fasteners, threaded elements, linear actuators, ball or lead screws, solenoids, and other actuators suitable for controllably displacing an end of the pusher pin 118 disposed in the hole 720, thereby adjusting the force generated by the pusher pin 118 upon contact with the chip package assembly 160.

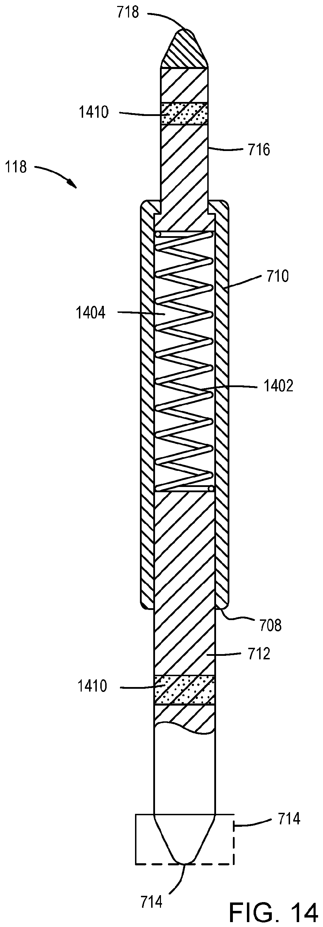

Figure 10 is another schematic partial side view of the workpress 106 of Figures 1A-1C having a conductive pusher pin 1018. The conductive pusher pin 1018 may be a commercially available spring pin that suitable for high frequency signal transmission through the pusher pin 1018. The pusher pin 1018 may also be constructed similar to any of the pusher pins 118 described below with reference to Figures 14-20, with the exception that the pusher pin 1018 is conductive tip to tip.

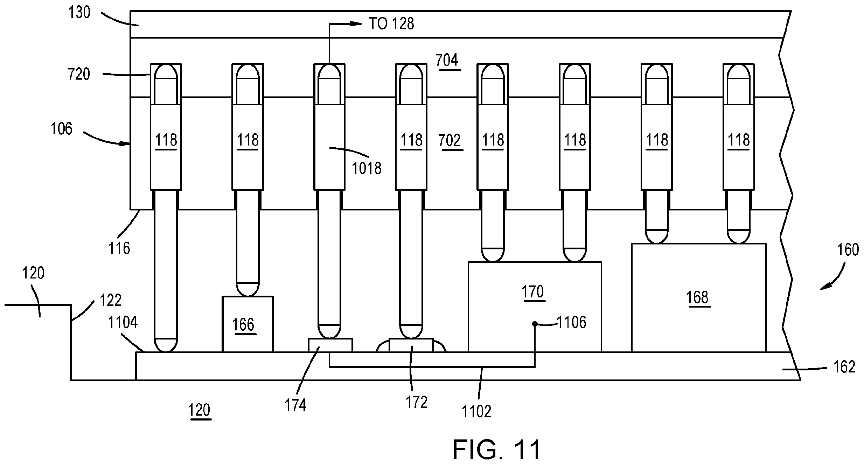

The conductive pusher pin 1018 may advantageously be utilized to provide communication between the test controller 128 and the test pad 174 disposed on the top surface of the chip package assembly 160. The conductive pusher pin 1018 is electrically coupled to a conductive pad 1002 disposed in the bottom of the hole 202. The conductive pad 1002 is coupled by wiring 1004 routed out through the workpress 106 to the test controller 128. The conductive pusher pin 1018 advantageously allows the test controller 128 to communicate with the chip package assembly 160 without having to utilize routings connected through the contact pads 124 of the test socket 120. An exemplary routing 1102 formed through the package substrate 162 and coupling the test pad 174 to circuitry 1106 of the die 170 is illustrated in Figure 11.

Figure 11 is a partial sectional view of the workpress 106 engaging the chip package assembly 160 disposed in the socket 120 of the automated test system 100 of Figure 1. As the actuator 108 advances the workpress 106 towards the socket 120, the pusher pins 118 (and 1018, if present) come in contact with the various components of the chip package assembly 160. As the various components of the chip package assembly 160 (e.g., a top surface 1104 of the package substrate 162, the stiffener 166, the surface mounted circuit elements 172, the test pad 174, and the dice 168, 170) generally have an uneven topography as illustrated in Figure 11, the stoke of the pusher pins 118, 1018 is sufficient to accommodate the different heights that the component extend above the top surface 1104 of the package substrate 162 while still applying a desired force to the chip package assembly 160. Since the pusher pins 118 may be configured to apply a small force to desired locations, force may be advantageously applied to fragile components, such as surface mounted circuit elements 172, without fear of damage to the circuit elements 172 or shorting between adjacent pins 118 or other components of the chip package assembly 160 due to the non-conductive nature of the pusher pin 118. Moreover, as the force is generally distributed across the entire chip package assembly 160, robust connections between the solder bumps 164 and contact pads 124 is advantageously realized. Additionally, the stoke of the pusher pins 118 enables adjacent surfaces of varying heights, such as the tops of the dice 168, 170, to be accommodated without fear of overstressing the higher die (*e.g.*, die 168) as would be the case with conventional workpresses having non-conforming package contact surfaces.

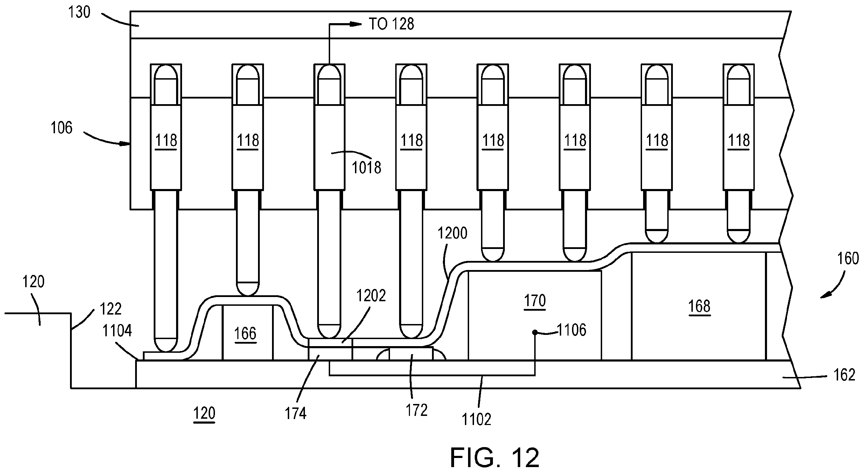

Figure 12 is another partial sectional view of the workpress 106 engaging the chip package assembly 160 disposed in the socket 120 of the automated test system 100 of Figure 1. In Figure 12, the workpress 106 has a layer of thermal interface material (TIM) 1200 disposed between the tips 714 of the pusher pins 118 and the components of the chip package assembly 160. The TIM 1200 may be utilized to further spread and distribute the force of the pins 118 across the top surface of the chip package assembly 160.

In the example depicted in Figure 12, the TIM 1200 is in the form of a sheet of compliant material. The sheet of TIM 1200 may include a hole 1202 positioned above the test pad 174, thereby facilitating direct contact between the conductive pusher pin 1018 and the test pad 174 so that signal transmission may be maintained.

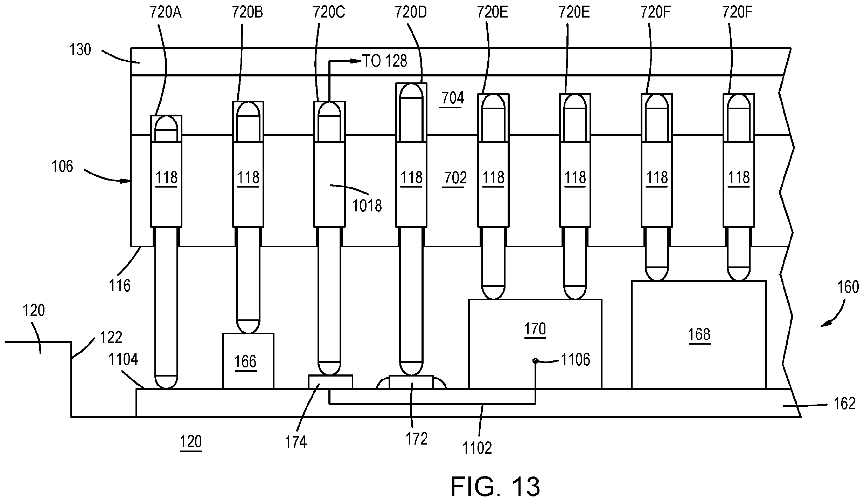

Figure 13 is another partial sectional view of the workpress 106 engaging the chip package assembly 160 disposed in the socket 120 of the automated test system 100 of Figure 1. In Figure 13, the second section 704 of the workpress 106 has holes 720 of varying depths so that the force applied by the pusher pins 118 may be best tailored to suit the height and type of package component that an individual pin 118 contacts during testing of the chip package assembly 160.

As discussed above, the force generated by each pusher pin 118 disposed in the workpress 106 is controlled by selecting the parameters of the depth 750 of the 5 hole 720, along with the spring constant and the length of the each pusher pin 118. These parameters may be selected so that all the pusher pins 118 exert a uniform force per unit displacement, or that. at least one or all of the pusher pins 118 exert different forces per unit displacement.

For example, it may be desirable for the pusher pin 118 contacting the top surface 1104 of the package substrate 162 to apply a relatively higher force than the pusher pin 118 contacting the top of the die 170. Thus, the pusher pin 118 contacting the top surface 1104 of the package substrate 162 may be disposed in a hole 720_{A} that is shallower than the hole 720_{E} in which the pusher pin 118 contacting the top of the die 170 is disposed. Similarly, it may be desirable for the pusher pin 118 contacting the top surface of the stiffener 166 to apply a relatively high force, and thus the pusher pin 118 contacting the top surface of the stiffener 166 may be disposed in a hole 720_{B} that is shallower in proportion to the difference that the stiffener 166 and die 170 project above the top surface 1104 of the package substrate 162 than the hole 720_{E} in which the pusher pin 118 contacting the top of the die 170 is disposed. Furthermore, it may be desirable for the pusher pin 118 contacting the top surface of the test pad 174 to apply a relatively higher force than a force applied to the surface mounted circuit elements 172 even though the surface mounted circuit elements 172 and test pad 174 extend about the same amount above the top surface 1104 of the package substrate 162. Thus the pusher pin 118 contacting the test pad 174 may be disposed in the hole 720_{C} that is shallower than the hole 720_{D} in which the pusher pin 118 contacting the and surface mounted circuit elements 172 is disposed. Similarly, it may be desirable for the pusher pin 118 contacting the top surface of the die 170 to apply about the same force as the pusher pin 118 contacting the top surface of the die 168. Since the die 168 has a top surface that extends to a greater height above the top surface 1104 of the package substrate 162 than the die 170, the pusher pin 118 contacting the die 168 may be disposed in the hole 720_{E} that is shallower than the hole 720_{F} in which the pusher pin 118 contacting the and die 168 is disposed so that the forces applied to both dice 168, 170 are essentially equal.

Although Figures 11-13 provide example having the appearance of a uniform distribution of pusher pins 118, any pusher pins distribution described above, such as but not limited to that described with reference to Figures 2-6 may be utilized. Moreover, the pusher pins 118 are not limited to having a uniform stoke, spring constant or force per unit displacement, but rather any one or more of the pusher pins 118 disposed in the workpress assembly 104 may have one or more of the stoke, spring constant or force per unit displacement different than one or more other pusher pins 118 disposed within the same workpress assembly 104.

Figure 14 show a perspective of an exemplary pusher pin 118. The pusher pin 118, which may be adapted from a pogo pin, pusher pin, buckling pin, cobra pin, microelectromechanical (MEMS) pin and the like, includes a first plunger 712, a second plunger 716 and a spring 1402. In one example, the plungers 712, 716 may be displaced axially through a distance (e.g., stroke) of about 0.5 to about 2.5 millimeters. In one example, an electrically insulative (e.g., discontinuous) path is defined between the exposed opposite ends of the first and second plunger 712, 716 through the pusher pin 118. The electrically insulative path defined through the pusher pin 118 prevents the pusher pin 118 from inadvertently shorting circuits that may be in contact with the pusher pin 118 when in use. It is noted that the pusher pin 118 described herein although for use with DUTs, is not intended for use in locations that require communication of an electric signal, ground or power for which a conductive pusher pin, such as the conductive pusher pin 1018 or equivalent, is utilized.

At least one of the tip 714 of the first plunger 712, the first plunger 712, the second plunger 716 and a tip 718 of the second plunger 716 is fabricated from, has a portion thereof, and/or is coated with a dielectric material that provides electrical signal isolation (i.e., non-transmission) through the pusher pin 118. In the example depicted in Figure 14, several examples locations of where dielectric portions 1410 that generate an electrical discontinuity through the pusher pin 118 are illustrated.

The pusher pin 118 may be fabricated from a material suitably rigid enough to withstand an axial compression force exerted on the pusher pin 118 when in use with a DUT. For example, the pusher pin 118 is configured to withstand axial compression force of up to about 1600 grams In one example, the pusher pin 118 maybe fabricated from a carbon-based materials, fiber-reinforced plastic, metals, rigid polymers or other suitable material. Suitable metals include brass, stainless steel, beryllium copper and titanium, among others. The pusher pin 118 maybe fabricated form one or more materials, and in one example, at least a portion 1410 of the pusher pin 118 is fabricated from a dielectric material so that the pusher pin 118 is not conductive from tip 714 to tip 718.

The spring 1402 is fabricated from a conductive or non-conductive material and is disposed between the first plunger 712 and the second plunger 716. The spring 1402 biases the first plunger 712 away from the second plunger 716. The spring 1402 may be disposed within or outside of the case 710. In the example depicted in Figure 14, the spring 1402 is disposed in a cavity 1404 of the case 710. In one example, the spring 1402 is selected to generate a force of between about 0.15 to 1.00 newtons (N) at about half the stroke of the second plunger 716.

As discussed above, an electrically insulative path is defined through the pusher pin 118. That is, an open circuit is formed between the tips 714, 718 of the plungers 712, 716 that defined the length of the pusher pin 118. The electrically insulative path defined through the pusher pin 118 generally prevents the pusher pin 118 from inadvertently shorting circuits that may be in contact with the tips 714, 718 of the pusher pin 118 when in use. To achieve an electrically insulative path through the pusher pin 118, various elements of the pusher pin 118 may be made of or coated with an electrically insulative material so that an open circuit is formed between exposed tips 714, 718 of the pusher pin 118 as discussed above. The electrically insulative material may be a ceramic, a form of rubber or latex, plastic, glass, or other suitable electrically insulative material. The electrically insulative material may also be an electrically non-conductive coating applied over a dielectric or conductive base material. The electrically non-conductive coating may comprise a thin film of ceramic, a form of rubber or latex, plastic, glass, or other suitable electrically insulative material.

Optionally and as additionally shown in Figure 14, the tip 714, such may optionally be electrically insulative, may have a width that is wider than an outer diameter of the case 710, as shown in phantom. The wide tip 714, as shown in phantom, advantageously distributes the force generated by the pusher pin 118 across a larger area when contacting a die or other DUT, thus reducing the pressure applied to the DUT and decreasing the probability of the DUT becoming damaged through interaction with the pusher pin 118. Additionally, in embodiments where the tip 714 is electrically insulative, the tip 714 cannot short adjacent circuits that are in contact with the tip 714, thus allowing the use of the pusher pin 118 with near and even in contact with solder connections and exposed circuit elements, such as the surface mounted circuit elements 172.

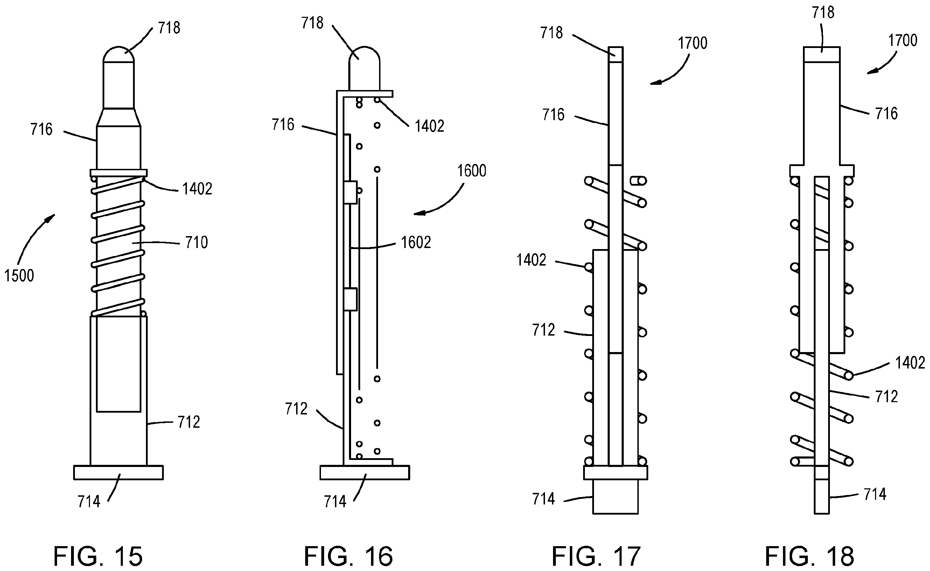

Figure 15 is a perspective of an exemplary pusher pin 1500 having an electrically insulative path defined therethrough. The pusher pin 1500 may be fabricated the same as the pusher pin 118 described above, except wherein the spring 1402 is disposed on the exterior of the case 710.

In the example depicted in Figure 15, the tip 714 is electrically insulative to provide the electrically insulative path defined through the pusher pin 1500. The electrically insulative tip 714 may be fabricated from a ceramic, a form of rubber or latex, plastic, glass, or other suitable electrically insulative material. The electrically insulative tip 714 may alternatively be fabricated with an electrically non-conductive coating applied over a dielectric or conductive base material, the coating comprised a thin film of ceramic, a form of rubber or latex, plastic, glass, or other suitable electrically insulative material. The electrically insulative tip 714 provides an open circuit between the tips 714, 718 of the pusher pin 118, thus making the pusher pin 118 non-conductive.

The enlarged width of the electrically insulative tip 714 advantageously distributes the force generated by the pusher pin 118 across a larger area when contacting a die or other DUT as compared to conventional pusher pins, thus decreasing the probability of the DUT becoming damaged through interaction with the pusher pin 118.

Figure 16 is a perspective of an exemplary pusher pin 1600 having an electrically insulative path defined therethrough. The pusher pin 1600 may be fabricated the same as the pusher pins 118, 1500 described above, except wherein the exemplary pusher pin 1600 has a slide mechanism 1102 coupling the plungers 712, 716. The slide mechanism 1102 allows one plunger member, e.g., the plunger 712, to slide linearly relative to the other plunger member, e.g., the plunger 716. The slide mechanism 1102 may be configured as any suitable linear slide, such as one or more guides slideably mounted to a rail, that enables the plungers 712, 716 to move relative to each other. A spring 1402 is coupled to the plungers 712, 716 and biases the tips 714, 718 of the pin 1600 in opposite directions.

The plungers 712, 716 may be fabricated from a stamped material, such as a metal, or be machined, casted, molded or otherwise formed. Alternatively, the plungers 712, 716 may be extruded, molded or otherwise formed from a rigid plastic.

The pusher pin 1600 has an electrically insulative path defined between opposite tips 714, 718 of the pusher pin 1600. The electrically insulative path defined between the opposite tips 714, 718 of the pusher pin 1600 may be realized in any number of ways. For example, the tip 714 of a first plunger 712 may include an electrically insulative tip 714. In another example, a tip 718 of a second plunger 716 may include an electrically insulative tip 714. Alternatively, at least one of the first and second plungers 712, 716 may be fabricated from or coated with an electrically insulative material, or include an electrically insulative portion that prevents electrical conduction between the opposite tips 714, 718 of the pusher pin 1600, such as described above.

Figures 17-18 are side and front views of an exemplary pusher pin 1700 having an external spring 1402, according to an embodiment. The pusher pin 1700 is configured with first and second plungers 712, 716 having an "H" configuration that guides the relative motion between the plungers 712, 716. In the embodiment depicted in Figures 17-18, each plunger 712, 716 has a flat form that is turned at an angle, such as 30-90 degrees, relative to the other plunger 712, 716 so that the legs of the "H" configuration of each plunger 712, 716 can engage with each other. The plungers 712, 716 may be fabricated from stamped materials, such as metals or rigid plastic.

As with the other pins described above, the pusher pin 1700 has an electrically insulative path defined between opposite tips 714, 718 of the pusher pin 1700. The electrically insulative path defined between the opposite tips 714, 718 of the pusher pin 1600 may be realized in any number of ways. For example, the tip 714 of a first plunger 712 may include an electrically insulative tip 714. In another example, a tip 718 of a second plunger 716 may include an electrically insulative tip 714. Alternatively, at least one of the first and second plungers 712, 716 may be fabricated from or coated with an electrically insulative material, or include an electrically insulative portion that prevents electrical conduction between the opposite tips 714, 718 of the pusher pin 1700, such as described with reference to Figures 4-7.

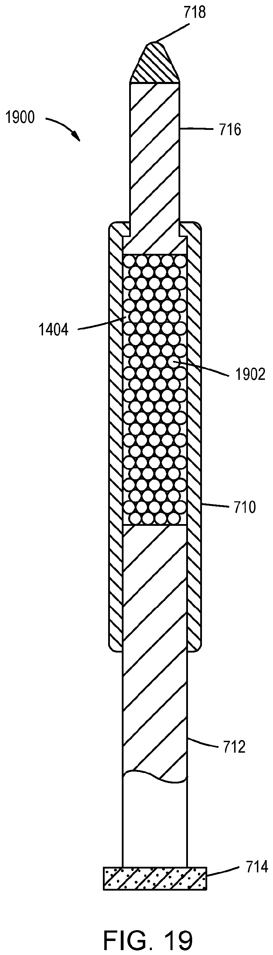

Figure 19 is a sectional view of an exemplary pusher pin 1900 having a spring 1902 fabricated from a compressible, resilient material. The compressible, resilient material comprising the spring 1902 may be fabricated from foam, an elastomer or plastic spheres. The spring 1902 may be fabricated from electrically conductive or insulative material.

As with the other pins described above, the pusher pin 1900 has an electrically insulative path defined between opposite tips 714, 718 of the pusher pin 1900. The electrically insulative path defined between the opposite tips 714, 718 of the pusher pin 1900 may be realized in any number of ways. For example, the tip 714 of a first plunger 712 may include an electrically insulative material. In another example, a tip 718 of a second plunger 716 may include an electrically insulative material. Alternatively, at least one of the first and second plungers 712, 716 may be fabricated from or coated with an electrically insulative material, or include an electrically insulative portion that prevents electrical conduction between the opposite tips 714, 718 of the pusher pin 1400, such as described above.

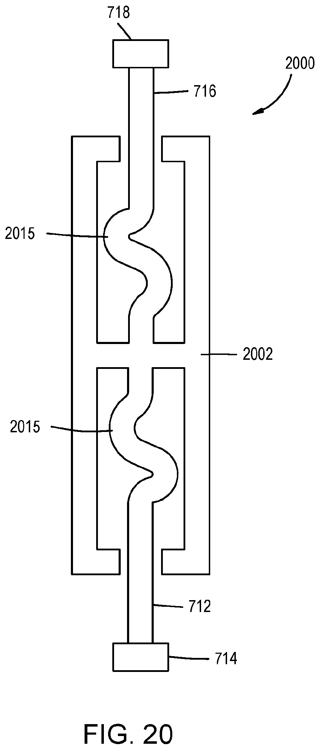

Figure 20 is a side view of an exemplary pusher pin 2000 having a unitary construction that incorporates a spring form, according to an embodiment. That is, at least one spring 2015 and the plungers 712, 716 are made from a single mass of material to provide the unitary construction. For example, the unitary construction may be achieved through stamping, machining, MEMS fabrication techniques, 3D printing or other suitable technique.

In the embodiment depicted in Figure 20, two springs 2015 are utilized which are coupled to a frame 2002 at one end. The opposite ends (e.g., tips 714, 718) of each spring 2015 are coupled to a respective one of the plungers 712, 716. In one example, the springs 2015 are flat springs.

The frame 2002 laterally surrounds the plungers 712, 716 and springs 2015 to provide a guide that orients the pusher pin 2000 within the receiving hole in which the pusher pin 2000 is formed. The tips 714, 718 extend axially through a gap in the frame 2002 a sufficient distance to allow a desired range of motion of the plungers 712, 716 without the tips 714, 718 retracting within the bounds of the frame 2002.

As with the other pins described above, the pusher pin 2000 has an electrically insulative path defined between opposite tips 714, 718 of the pusher pin 2000. The electrically insulative path defined between the opposite tips 714, 718 of the pusher pin 1600 may be realized in any number of ways. For example, the tip 714 of a first plunger 712 may include an electrically insulative tip 714. In another example, a tip 718 of a second plunger 716 may include an electrically insulative tip 714. Alternatively, at least one of the first and second plungers 712, 716, springs 2015 may be fabricated from or coated with an electrically insulative material, or include an electrically insulative portion that prevents electrical conduction between the opposite tips 714, 718 of the pusher pin 2000, such as described with reference to Figures 4-7. In yet another example, the portion of the frame 2002 separating the springs 2015 may be fabricated from or coated with an electrically insulative so as to provide an open circuit between the tips 714, 718 of the pusher pin 2000.

With all the pusher pins described above, the pusher pins may be sized to allow a pitch between axially aligned pusher pins of 1.0 mm centerline to centerline pitch. In other examples, the centerline to centerline pitch may be as small as 0.4 mm. The end to end (i.e., between the tips 714, 718) range of motion (i.e., axial displacement) of the pusher pins may be in the range of 0.7 to 2.0 mm. The pusher pins may generate between 5.0 and 0.15 newtons of force.

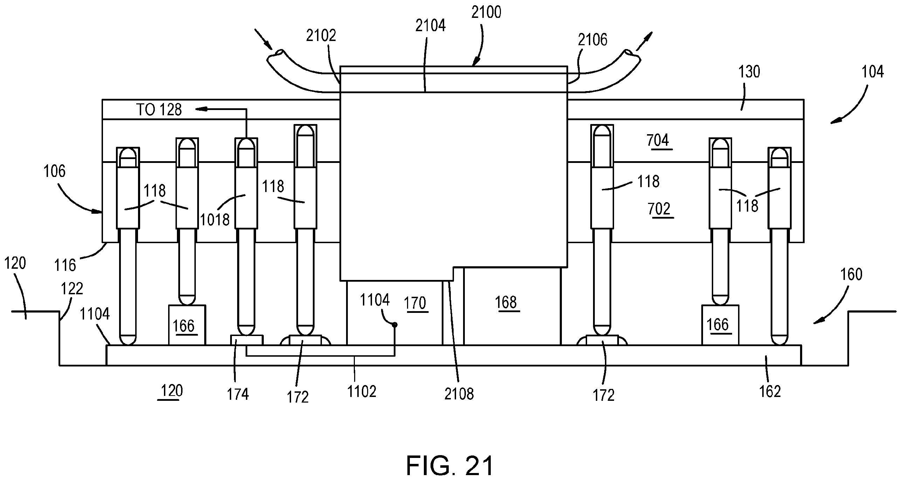

Figure 21 is a side view of a workpress 106 of the chip package assembly test system 100 of Figures 1A-1C having an optional temperature control block 2100. The temperature control block 2100 is integrated into the workpress 106 such that a lower surface 2108 of the temperature control block 2100 is exposed to the chip package assembly 160 disposed in the socket 120 through the bottom surface 116 of the workpress 106. The temperature control block 2100 may be coupled to the workpress 106 directly, or alternatively coupled to the mounting plate 130.

The lower surface 2108 of the temperature control block 2100 may be contoured to substantially conform with the topography of the dice 168, 170 mounted to the package substrate 162. Stated differently, the lower surface 2108 of the temperature control block 2100 may have a geometry that mates with the top surfaces of each die 168, 170 even though each die 168, 170 extends to a different height above the top surface 1104 of the package substrate 162. For example, the lower surface 2108 of the temperature control block 2100 may include one or more regions of parallel planar surfaces, such as steps, wherein each region is configured to engage and mate with a top surface of a respective one of the dice 168,170.

The temperature control block 2100 may additionally include at least one cooling channel 2104 (shown in phantom in Figure 21). The channel 2104 extends between an inlet port 2102 and an outlet port 2106 formed in the temperature control block 2100. The inlet and outlet ports 2102, 2106 allow a cooling medium, such as water, oil, refrigerant, liquid nitrogen and the like, to be circulated through the channel 2104, thus cooling the block 2100 and effectively sinking heat generated from the dice 168, 170 under test. In another example, the temperature control block 2100 may be utilized to heat the dice 168, 170 undergoing a high temperature test, for example by using heated fluid circulated through the channel 2104 or by utilizing a resistive heater disposed in or on the temperature control block 2100.

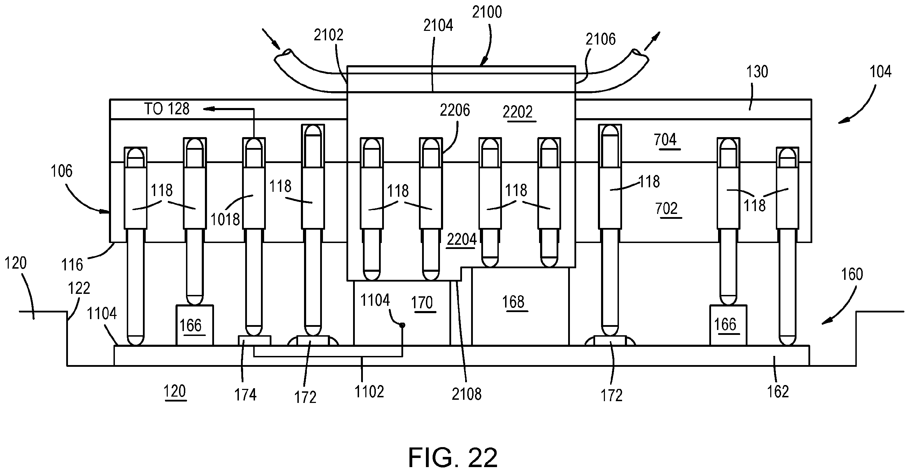

Figure 22 is a side view of a workpress 106 of the chip package assembly test system 100 of Figures 1A-1C having an optional temperature control block 2100 that includes integrated pusher pins 118. The workpress 106 of Figure 22 is constructed essentially the same as the workpress 106 of Figure 22 except that the workpress 106 of Figure 22 include a plurality of pusher pins 118 for contacting the dice 168, 170.

In the example depicted in Figure 22, the temperature control block 2100 is split into two sections 2202, 2204 to enable the fabrication of pusher pin holes 2206. The pusher pin holes 2206 are fabricated in the sections 2202, 2204 of the temperature control block 2100 similar to the holes 202 fabricated in the sections 702, 704 of the workpress 106 such that the pusher pins 118 are captured within the temperature control block 2100.

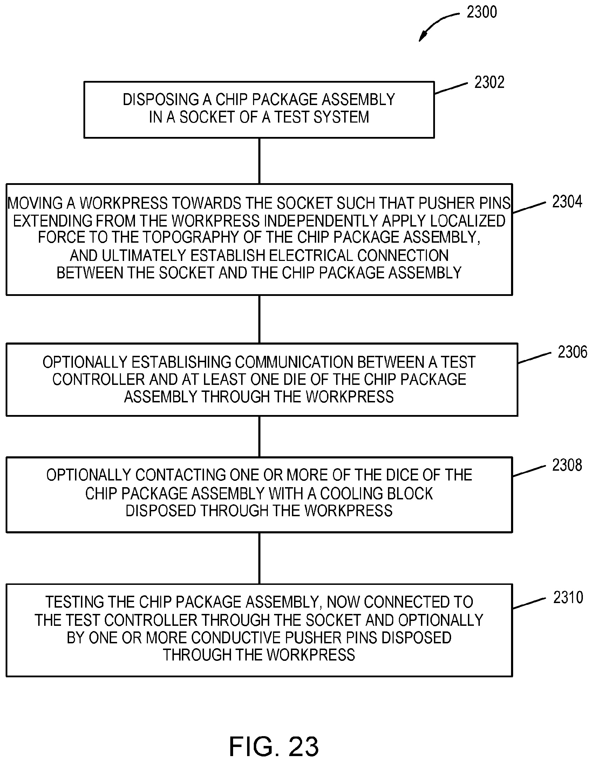

Although not shown, a layer of TIM, such as the TIM 1200 illustrated in Figure 12, may optionally be utilized between the temperature control block 2100 and dice 168, 170 in either of the examples described in Figures 23-22. Moreover, the temperature control block 2100 may be incorporated in any of the examples described in Figures 2-9.

Figure 23 is a flow diagram of a method 2300 for testing a chip package assembly, such as the chip package assembly 160 or other suitable chip package. The method 2300 begins at operation 2302 by robotically disposing a chip package assembly 160 in the socket 120 of the test system 100.

At operation 2304, the workpress 106 is moved towards the socket 120 such that the pusher pins 118 extending from the workpress 106 engage and dynamically conform to the multi-planar topography of the chip package assembly 160. The workpress 106 is displaced towards the socket 120 a predefined distance so that the pusher pins 118 apply sufficient force to the chip package assembly 160 to ensure good electrical contact between the chip package assembly 160 and pads 124 of the socket 120. The good electrical contact enables robust and effective signal transmission between the chip package assembly 160 and the test controller 128.

At operation 2304, the pusher pins 118 extending from the workpress 106 may optionally engage one region of the chip package assembly 160 with a greater density of pins 118 than another region. At operation 2304, the pusher pins 118 extending from the workpress 106 may optionally engage one region of the chip package assembly 160 with pins 118 having a size that is different than pins 118 engaging another region of the chip package assembly 160. At operation 2304, one pusher pin 118 extending from the workpress 106 may optionally apply a greater force to one region of the chip package assembly 160 than the force applied by different pins 118 to another region of the chip package assembly 160. At operation 2304, one pusher pin 118 extending from the workpress 106 may optionally apply a greater force to one region of the chip package assembly 160 than the force applied by different pins 118 to another region of the chip package assembly 160, even though both pusher pins 118 are displaced substantially the same distance in one example, or are displaced substantially a different distance in a second example. At operation 2304, one pusher pin 118 extending from the workpress 106 may optionally apply a force to one region of the chip package assembly 160 that is substantially equal to the force applied by different pins 118 to another region of the chip package assembly 160, even though both pusher pins 118 are displaced substantially the same distance one example, or are displaced substantially a different distance in a second example.

At optional operation 2306, the test controller 128 communicates with at least one die, for example die 170, of the chip package assembly 160 though a conductive pusher pin 1018 disposed through the workpress 106. At optional operation 2308, one or more of the dice 168, 170 are cooled by conducting heat through a temperature control block 2100 disposed through the workpress 106.

At operation 2310, the chip package assembly 160, now connected to the controller 128 through the socket 120 and optionally one or more conductive pusher pins 1018 disposed through the workpress 106, is tested in accordance with a test routine executed by the test controller 128. As described above, the test may be one or more of a DC test routine, a burn-in routine, post burn-in routine, a final test routine or other predefined test routine to be performed on the chip package assembly 160.

Other examples of the disclosure generally provide electrically insulative pusher pins for use in integrated circuit package test assemblies. In first examples described herein, techniques are provided that allow for a distributed force to be applied over a larger contact area, resulting in reduced pressure applied to DUTs, such as integrated circuit chips, integrated circuit chip packages, printed circuit boards, and the like, thereby reducing the risk of die and/or package delamination and die and/or substrate cracks. In second examples described herein, techniques are provided that include an electrically insulative path defined between opposite ends of a pusher pin. The electrically insulative path defined through the pusher pin prevents the pusher pin from inadvertently shorting circuits that may be in contact with the pusher pin when in use with DUTs.

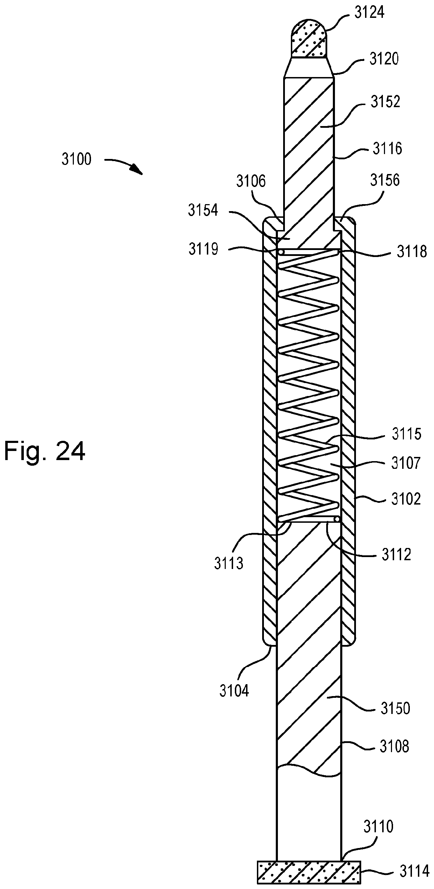

Figure 24 show a perspective of an exemplary pusher pin 3100. The pusher pin 3100, which may be adapted from a pogo pin, spring pin, buckling pin, cobra pin, microelectromechanical (MEMS) pin and the like, includes a first plunger member 3108, a second plunger member 3116 and a spring 3115. One or more of the pusher pins described above with reference to Figures 1-23 may be configured as the pusher pin 3100. In one example, an electrically insulative path is defined between the exposed opposite ends of the first and second plunger members 3108, 3116 through the pusher pin 3100. The electrically insulative path defined through the pusher pin 3100 prevents the pusher pin 3100 from inadvertently shorting circuits that may be in contact with the pusher pin 3100 when in use. It is noted that the pusher pin 3100 described herein although for use in DUTs, is not intended for use in locations that require communication of an electric signal, ground or power for which a conventional pusher pin is commonly utilized.

The first plunger member 3108 has a body 3150. The body 3150 includes a first end 3113 and a second end 3110. The body 3150 may be cylindrical or have another sectional geometry. The body 3150 may be fabricated from a material suitably rigid enough to withstand an axial compression force exerted on the pusher pin 3100 when in use with a DUT. For example, the body 3150 is configured to withstand axial compression force of up to about 1000 grams In one example, the body 3150 maybe fabricated from a carbon-based materials, fiber-reinforced plastic, metals, rigid polymers or other suitable material. Suitable metals include brass, stainless steel, beryllium copper and titanium, among others. The body 3150 maybe fabricated form one or more materials, and in one example, at least a portion of the body 3150 is fabricated from a dielectric material so that the body 3150 is not conductive from the end 3113 to the end 3110.

The second plunger member 3116 also has a body 3152. The body 3152 may be fabricated from the same materials as described above with reference to the body 3150 of the first plunger member 3108. The bodies 3150, 3152 may be fabricated from the same materials, or fabricated from different materials. In some examples, at least one of the bodies 3150, 3152 is non-conductive end to end, while in other example, both bodies 3150, 3150 may be conductive end to end. The body 3152 of the second plunger member 3116 includes a first end 3119 and a second end 3120.

The pusher pin 3100 may further include a shell 3102. The shell 3102 optionally may be part of the first plunger member 3108. The shell 3102 may be fabricated from the same materials as described above with reference to the body 3150 of the first plunger member 3108. The body 3150 and the shell 3102 may be fabricated from the same materials, or fabricated from different materials. In some examples, at least one of the body 3150 and the shell 3102 is non-conductive end to end, while in other example, both the body 3150 and shell 3102 may be conductive end to end.

The shell 3102 has a first end 3104 and a second end 3106. A cavity 3107 is formed through the shell 3102 from the first end 3104 to the second end 3106. The first end 3113 of the first plunger member 3108 is disposed in the cavity 3107 through the first end 3104 of the shell 3102. In one example, the first end 3113 of the first plunger member 3108 is fixed in the cavity 3107 of the shell 3102 so that the first plunger member 3108 does not move relative to the shell 3102. The first plunger member 3108 may be fixed to the shell 3102 in any suitable manner. For example, the first plunger member 3108 may be fixed to the shell 3102 using adhesives, a press fit engagement, a swaged connection, threads, crimping, brazing, welding, fasteners or other suitable technique. In another example, the first end 3113 of the first plunger member 3108 is movably disposed in the cavity 3107 of the shell 3102 so that the first plunger member 3108 may move axially relative to the shell 3102. In such embodiment where it is desirable for the first plunger member 3108 to move axially relative to the shell 3102, the first end 3113 of the first plunger member 3108 may be captured in the cavity 3107 of the shell 3102 as further described below with reference to the engagement of the second plunger member 3116 with the cavity 3107 of the shell 3102.

As just mentioned above, the second plunger member 3116 is engaged with the cavity 3107 of the shell 3102 in a manner that allows for the second plunger member 3116 to move axially relative to the shell 3102. For example, the first end 3119 of the second plunger member 3116 is disposed in the cavity 3107 through the second end 3106 of the shell 3102. The shell 3102 includes a flange 3156 that has an inner diameter sized to allow the body 3152 of the second plunger member 3116 to extend through the flange 3156 so that the second plunger member 3116 may be displaced axially through the second end 3106 of the shell 3102 without significant restriction of movement. The flange 3156 may be formed by crimping the shell 3102, heading, or other suitable technique. The inner diameter of the flange 3156 is smaller than a diameter of a head 3154 formed at the second end 3106 of the second plunger member 3116, thus capturing the second plunger member 3116 within the cavity 3107 by preventing the second plunger member 3116 from completely sliding out of the cavity 3107 through the second end 3106 of the shell 3102. In one example, the second plunger member 3116 may be displaced axially through a distance of about 0.5 to about 2.5 millimeters.

The spring 3115 is fabricated from a conductive or non-conductive material and is disposed between the first plunger member 3108 and the second plunger member 3116. The spring 3115 biases the first plunger member 3108 away from the second plunger member 3116. The spring 3115 may be disposed within or outside of the shell 3102. In the example depicted in Figure 24, the spring 3115 is disposed in the cavity 3107 of the shell 3102.

For example, the spring 3115 has a first end 3112 and a second end 3118. The first end 3112 of the spring 3115 is disposed against the first end 3113 of the body 3150 of the first plunger member 3108. The end 3118 of the spring 3115 is disposed against the first end 3119 of the body 3152 of the second plunger member 3116. The distance between the first end 3113 of the body 3150 of the first plunger member 3108 and the flange 3156 of the shell 3102 is selected so that the spring 3115 generates a determined pre-load force when the second plunger member 3116 is fully extended from the shell 3102. In one example, the spring 3115 is selected to generate a force of between about 0.15 to 1.00 newtons (N) at about half the stroke of the second plunger member 3116.

As discussed above, an electrically insulative path is defined through the pusher pin 3100. That is, an open circuit is formed between the second ends 3110, 3120 of the plunger members 3108, 3116 that defined the length of the pusher pin 3100. For example, the electrically insulative path is defined between the exposed second end of the first plunger member 3108 and the exposed second end of the second plunger member 3116 through the pusher pin 3100. The electrically insulative path defined through the pusher pin 3100 generally prevents the pusher pin 3100 from inadvertently shorting circuits that may be in contact with the second ends 3110, 3120 of the pusher pin 3100 when in use. To achieve an electrically insulative path through the pusher pin 3100, various elements of the pusher pin 3100 may be made of or coated with an electrically insulative material so that an open circuit is formed between exposed second ends 3110, 3120 of the pusher pin 3100. The electrically insulative material may be a ceramic, a form of rubber or latex, plastic, glass, or other suitable electrically insulative material. The electrically insulative material may also be an electrically non-conductive coating applied over a dielectric or conductive base material. The electrically non-conductive coating may comprise a thin film of ceramic, a form of rubber or latex, plastic, glass, or other suitable electrically insulative material.

In the example depicted in Figure 24, the second end 3110 of the first plunger member 3108 may include electrically insulative tip 3114. The electrically insulative tip 3114 may be made from or coated with any of the electrically insulative materials described above, including an electrically non-conductive coating applied over a dielectric or conductive base material, the coating comprised a thin film of ceramic, a form of rubber or latex, plastic, glass, or other suitable electrically insulative material. The electrically insulative tip 3114 may be part of the body 3150, or be separately connected to the second end 3110 of the first plunger member 3108. The electrically insulative tip 3114 provides an open circuit between the second ends 3110, 3120 of the pusher pin 3100, thus making the pusher pin 3100 non-conductive.

Optionally and as additionally shown in Figure 24, the electrically insulative tip 3114 may have a width that is wider than an outer diameter of the shell 3102. The wide tip 3114 advantageously distributes the force generated by the pusher pin 3100 across a larger area when contacting a die or other DUT as compared to conventional pusher pins, thus reducing the pressure applied to the DUT and decreasing the probability of the DUT becoming damaged through interaction with the pusher pin 3100. Additionally, since the tip 3114 is electrically insulative, the tip 3114 cannot short adjacent circuits that are in contact with the tip 3114, thus allowing the use of widths for the second end 3120 of the pusher pin 3100 that are much wider than conventional pusher pins, thereby allowing contact forces to be advantageously spread much wider than conventional pusher pin designs.

In addition to the electrically insulative tip 3114 of the first plunger member 3108, the second end 3120 of the second plunger member 3116 may include an electrically insulative tip 3124. The electrically insulative tip 3124 may be made from or coated with any of the electrically insulative materials described above, including an electrically non-conductive coating applied over a dielectric or conductive base material, the coating comprised a thin film of ceramic, a form of rubber or latex, plastic, glass, or other suitable electrically insulative material. The electrically insulative tip 3124 may be part of the body 3152, or be separately connected to the second end 3120 of the second plunger member 3116. The electrically insulative tip 3124 provides an open circuit between the second ends 3110, 3120 of the pusher pin 3100, thus making the pusher pin 3100 non-conductive. Having the electrically insulative tips 3114, 3124 on both ends 3110, 3120 of the pusher pin 3100 advantageously allows the pin 3100 to engage circuits from either end of the pin 3100 without fear of shorting the circuits though electrical connection with another portion of the pin 3100 and another conductive object.

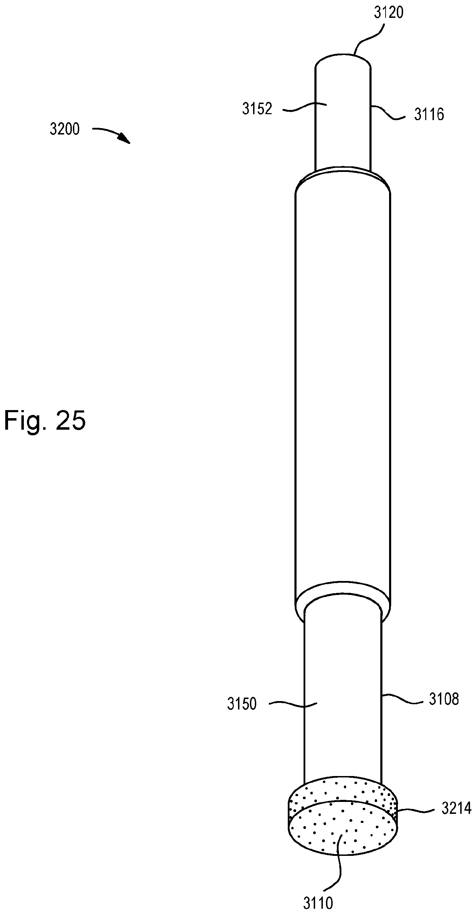

Figure 25 shows a perspective of an exemplary pusher pin 3200 having an electrically insulative tip 3214, according to an embodiment. The pusher pin 3200 may be fabricated the same as the pusher pin 3100 described above, except wherein the electrically insulative tip 3214 is disposed on the first plunger member 3108 without a second electrically insulative tip disposed on the end 3120 of the second plunger member 3116. The electrically insulative tip 3214 may be fabricated from a ceramic, a form of rubber or latex, plastic, glass, or other suitable electrically insulative material. The electrically insulative tip 3214 may alternatively be fabricated with an electrically non-conductive coating applied over a dielectric or conductive base material, the coating comprised a thin film of ceramic, a form of rubber or latex, plastic, glass, or other suitable electrically insulative material. The electrically insulative tip 3214 may be part of the body 3150, or be separately connected to the second end 3110 of the first plunger member 3108. In embodiments where the electrically insulative tip 3214 is separately connected to the second end 3110 of the first plunger member 3108, the tip 3214 may be connected to the body 3150 utilizing fasteners, adhesives, swaging, press-fit, threading, pins, or other suitable fastening technique. The electrically insulative tip 3114 provides an open circuit between the second ends 3110, 3120 of the pusher pin 3100, thus making the pusher pin 3100 non-conductive.

The enlarged width of the electrically insulative tip 3114 advantageously distributes the force generated by the pusher pin 3100 across a larger area when contacting a die or other DUT as compared to conventional pusher pins, thus decreasing the probability of the DUT becoming damaged through interaction with the pusher pin 3100.

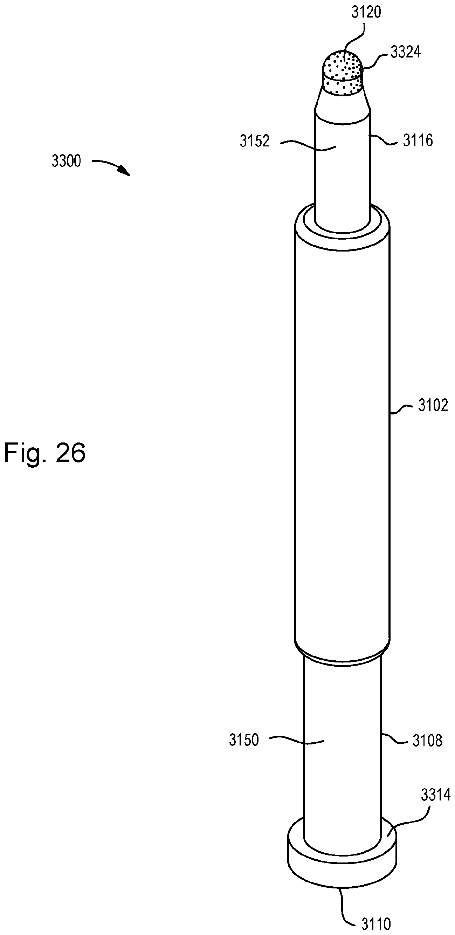

Figure 26 shows a perspective of an exemplary pusher pin 3300 having an electrically insulative tip 3324, according to an embodiment. The second end 3120 of the second plunger member 3116 may include the electrically insulative tip 3324. The electrically insulative tip 3324 may be made from or coated with any of the electrically insulative materials described above. The electrically insulative tip 3314 may alternatively be fabricated with an electrically non-conductive coating applied over a dielectric or conductive base material, the coating comprised a thin film of ceramic, a form of rubber or latex, plastic, glass, or other suitable electrically insulative material The electrically insulative tip 3324 may be part of the body 3152, or be separately connected to the second end 3120 of the second plunger member 3116. In embodiments where the electrically insulative tip 3324 is separately connected to the second end 3120 of the second plunger member 3116, the tip 3324 may be connected to the body 3152 utilizing fasteners, adhesives, swaging, press-fit, threading, pins, or other suitable fastening technique.

When the electrically insulative tip 3324 is part of the body 3152, both the tip 3324 and the body 3152 may be made of or coated with an electrically insulative material, such as any of the electrically insulative materials described with reference to the body 3152 of the second plunger member 3116. The tip 3324 and the body 3152 may be fabricated from the same materials, or fabricated from different materials. Since the tip 3324 is electrically insulative, the tip 3324 cannot short adjacent circuits that are in contact with the tip 3324. The electrically insulative tip 3324 provides an open circuit between the second ends 3110, 3120 of the pusher pin 3300, thus making the pusher pin 3300 non-conductive.

A tip 3314 of the first plunger member 3108 is also shown in Figure 26. The tip 3314 may be fabricated from a conductive or non-conductive material. The tip 3314 may have a width that is wider than an outer diameter of the shell 3102. The wide tip 3314 advantageously distributes the force generated by the pusher pin 3300 across a larger area when contacting a die or other DUT as compared to conventional pusher pins, thus decreasing the probability of the DUT becoming damaged through interaction with the pusher pin 3300. In embodiments that the tip 3314 is fabricated from or coated with an electrically insulative material, the tip 3314 cannot short adjacent circuits that are in contact with the tip 3314, thus allowing the use of widths for the second end 3110 of the pusher pin 3300 that are much wider than conventional pusher pins, thereby allowing contact forces to be advantageously spread much wider than conventional pusher pin designs.

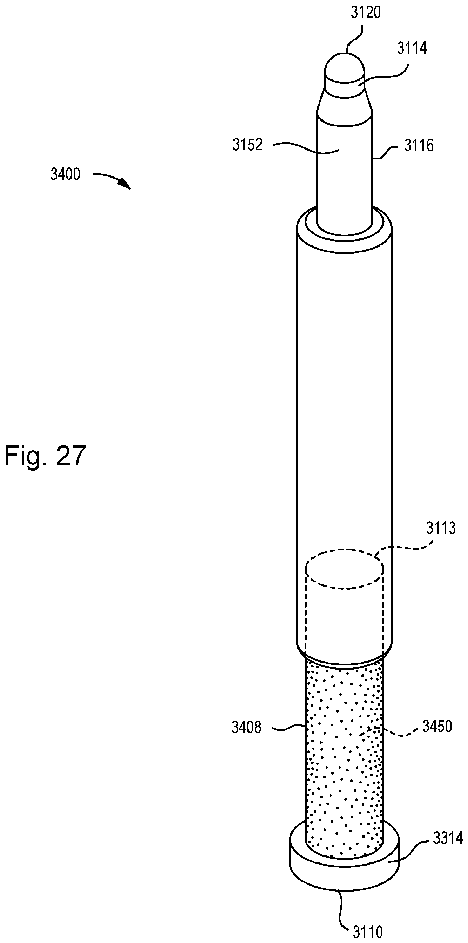

Figure 27 shows a perspective of an exemplary pusher pin 3400 having an electrically insulative first plunger member 3408, according to an embodiment. The first plunger member 3408 has a body 3450. The body 3450 includes a second end 3110. The body 3450 may be cylindrical or have another sectional geometry. The body 3450 may be fabricated from a material suitably rigid enough to withstand an axial compression force exerted on the pusher pin 3400 when in use with a DUT. For example, the body 3450 is configured to withstand axial compression force of up to about 1000 grams. In one example, the body 3450 maybe fabricated from a carbon-based materials, fiber-reinforced plastic, rigid polymers or other suitable electrically insulative material. The body 3450 maybe fabricated form one or more materials, and in one example, at least a portion of the body 3450 is fabricated from a dielectric material so that the body 3450 is not conductive from the end 3113 to the end 3110.

The electrically insulative first plunger member 3408 may include the tip 3314 that is part of the body 3450, or is separate from the body 3450. In embodiments where the tip 3314 is separately connected to the second end 3110 of the first plunger member 406, the tip 3314 may be connected to the body 3450 utilizing fasteners, adhesives, swaging, press-fit, threading, pins, or other suitable fastening technique.

When the tip 3314 is part of the body 3450, both the tip 3314 and the body 3450 may be made of or coated with an electrically insulative material, such as any of the electrically insulative materials described with reference to the body 3150 of the first plunger member 3108. The tip 3314 and the body 3150 of the first plunger member 3408 may be fabricated from the same materials, or fabricated from different materials. Since the first plunger member 3408 is electrically insulative, the first plunger member 3408 cannot short adjacent circuits that are in contact with the first plunger member 3408. The electrically insulative first plunger member 3408 provides an open circuit between the second ends 3110, 3120 of the pusher pin 3400, thus making the pusher pin 3400 non-conductive.

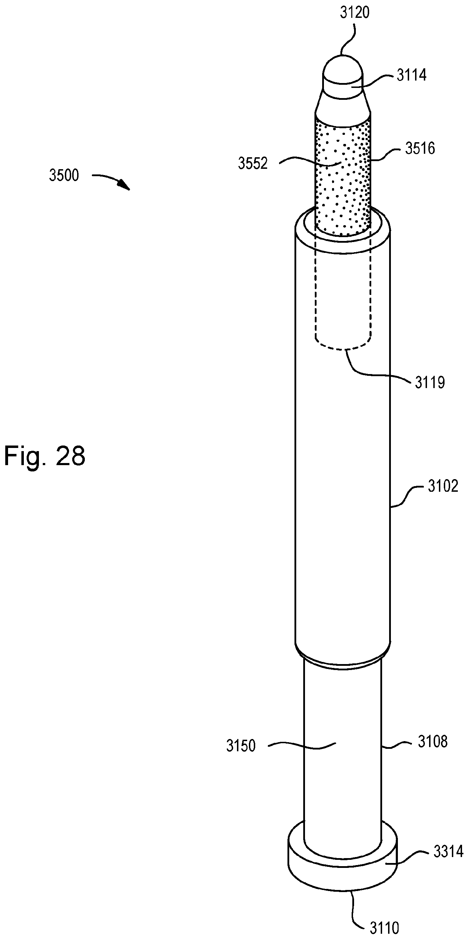

Figure 28 shows a perspective of an exemplary pusher pin 3500 having an electrically insulative second plunger member 3516, according to an embodiment. The second plunger member 3516 has a body 3552 fabricated from or coated with an electrically insulative material. The body 3552 includes a first end 3119 and a second end 3120. The body 3552 may be cylindrical or have another sectional geometry. The body 3552 may be fabricated from a material suitably rigid enough to withstand an axial compression force exerted on the pusher pin 3500 when in use with a DUT. For example, the body 3552 is configured to withstand axial compression force of up to about 1000 grams. In one example, the body 3552 maybe fabricated from a carbon-based materials, fiber-reinforced plastic, rigid polymers or other suitable electrically insulative material. The body 3552 maybe fabricated form one or more materials, and in one example, at least a portion of the body 3552 is fabricated from a dielectric material so that the body 3552 is not conductive from the end 3119 to the end 3120.

The electrically insulative second plunger member 3516 may include the tip 3124 that is part of the body 3552, or is separate from the body 3552. In embodiments where the tip 3124 is separately connected to the first end 3119 of the second plunger member 3516, the tip 3124 may be connected to the body 3552 utilizing fasteners, adhesives, swaging, press-fit, threading, pins, or other suitable fastening technique.

When the tip 3124 is part of the body 3552, both the tip 3124 and the body 3552 may be made of or coated with an electrically insulative material, such as any of the electrically insulative materials described with reference to the body 3152 of the second plunger member 3116. The tip 3124 and the body 3552 of the second plunger member 3516 may be fabricated from the same materials, or fabricated from different materials. Since the second plunger member 3516 is electrically insulative, the second plunger member 3516 cannot short adjacent circuits that are in contact with the second plunger member 3516. The electrically insulative first plunger member 3408 provides an open circuit between the second ends 3110, 3120 of the pusher pin 3500, thus making the pusher pin 3500 non-conductive.

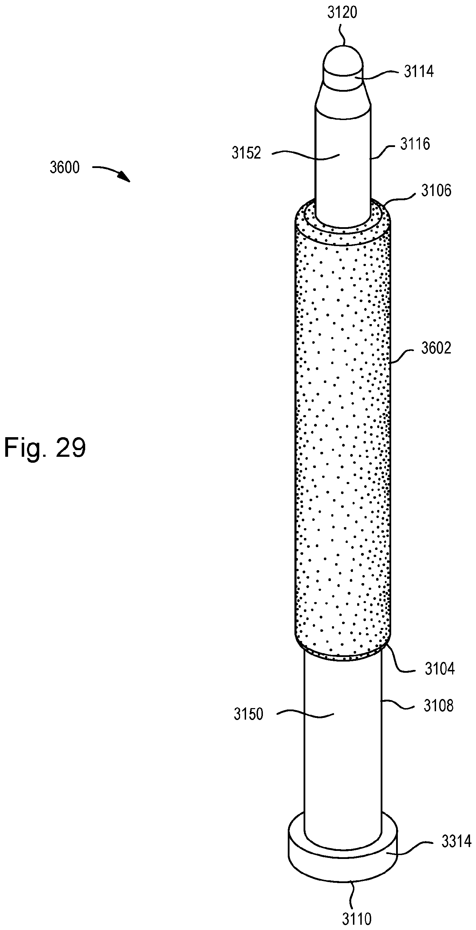

Figure 29 shows a perspective of an exemplary pusher pin 3600 having an electrically insulative shell 3602, according to an embodiment. The shell 3602 optionally may be part of the first plunger member 3108. The shell 3602 has a first end 3104 and a second end 3106. The shell 3602 may be fabricated from the same electrically-insulative materials as described above with reference to the body 3150 of the first plunger member 3108. The body 3150 and the shell 3602 may be fabricated from the same materials, or fabricated from different materials. In some examples, at least one of the shell 3602 and the body 3150 is electrically non-conductive from the first end 3104 to the second end 3106, while in other example, both the shell 3602 and the body 3150 may be conductive end to end.

The shell 3602 includes a flange 3156 that has an inner diameter sized to allow the body 3152 of the second plunger member 3116 to extend therethrough so that the second plunger member 3116 be displaced axially through the second end 3106 of the shell 3602 without significant restriction of movement. The flange 3156 may be formed by crimping the shell 3602, heading, or other suitable technique. The inner diameter of the flange 3156 is smaller than a diameter of a head 3154 formed at the second end 3106 of the second plunger member 3116, thus capturing the second plunger member 3116 within the cavity 3107 by preventing the second plunger member 3116 from completely sliding out of the cavity 3107 through the second end 3106 of the shell 3602.

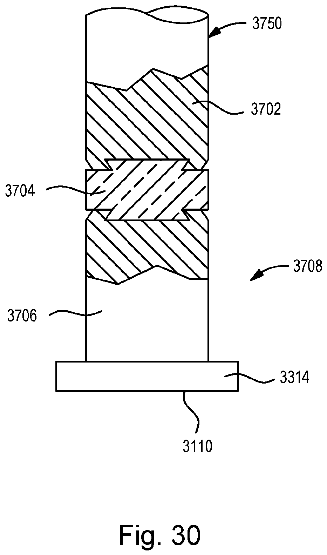

Figure 30 shows a front elevation of a portion of a first plunger member 3708 of an exemplary pusher pin illustrating an electrically insulative portion 3704 of the first plunger member 3708, according to an embodiment. The first plunger member 3708 includes a body 3750 made up of the electrically insulative portion 3704 and at least one other portion. The at least one other portion of the body 3750 of the first plunger member 3708 may be fabricated from a conductive material, such as a metal, or from a non-conductive material. All the portions of the body 3750 do not have to be fabricated from the same materials, as long as one portion, e.g., the portion 3704, is fabricated from a non-electrically conductive material.

In the example depicted in Figure 30, the first plunger member 3708 includes a first portion 3702 and a second portion 3706 that sandwich the electrically insulative portion 3704. However, the electrically insulative portion 3704 may be alternatively positioned adjacent one of the portions 3702, 3706 and not the other portion. The electrically insulative portion 3704 makes the body 3750 non-conductive. That is, the body 3750 is electrically non-conductive along length of the body 3750 from the first portion 3702 to the second portion 3706 due to the intervening non-conductive portion 3704. The electrically insulative portion 3704 may be fabricated from a ceramic, a form of rubber or latex, plastic, glass, or other suitable electrically insulative material. The electrically insulative portion 3704 may be coupled to the utilizing fasteners, adhesives, swaging, press-fit, threading, pins, or other suitable fastening technique.

Although the electrically insulative portion 3704 is shown as being part of the first plunger member 3708, any one or more of plunger member 3116 and the shell 3102 may have configured to include an electrically insulative portion 3704 as part of the body 3152 of the plunger member 3116 or shell 3102.

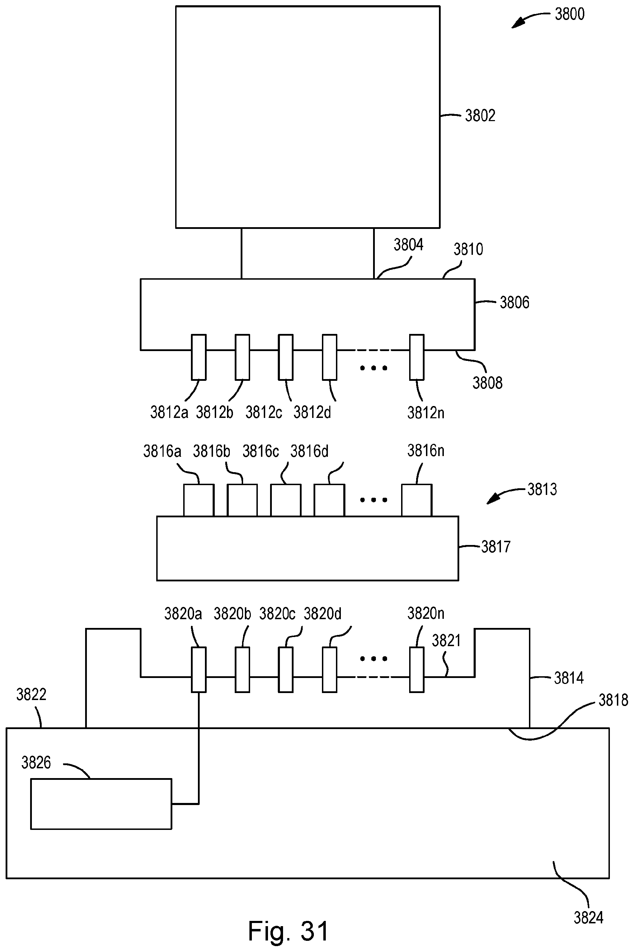

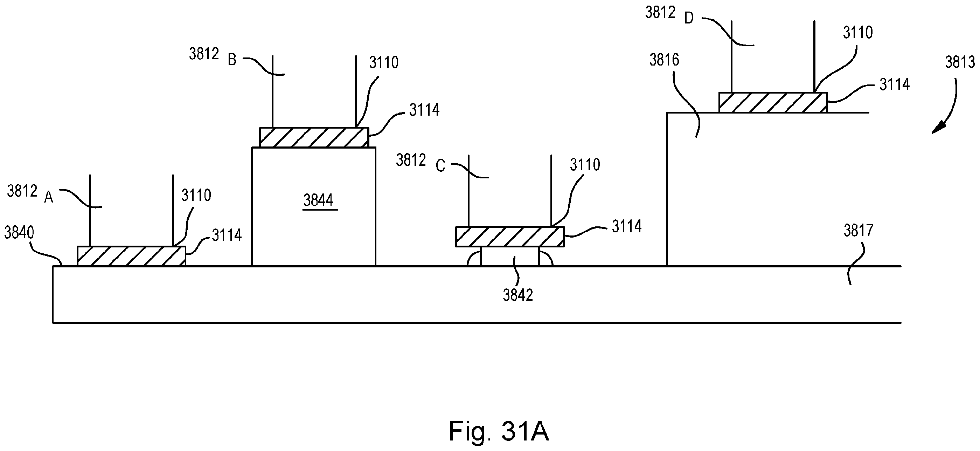

Figure 31 shows a schematic block diagram of an integrated circuit package test assembly 3800 that employs at least one of the pusher pins described herein, or other similar pusher pin. The test assembly 3800 may include an actuator 3802 having a bottom end 3804. The test assembly 3800 may further include a workpress 3806 having a top end 3810 and a bottom end 3808. The top end 3810 of the workpress 3806 mates with the bottom end 3804 of the actuator 3802. The bottom end 3808 of the workpress 3806 is embedded with a first plurality of pusher pins 3812a-3812n therein. At least one of the pusher pins 3812a-3812n may be configured as any of the pusher pins described herein or other similar conductive pusher pin. The test assembly 3800 may further include a socket 3814 having a top end 3821 and a bottom end 3818. The top end 3821 of the socket 3814 may include a second plurality of pusher pins 3820a-3820n inserted therein. At least one of the pusher pins 3820a-3820n may be configured as any of the pusher pins described herein or other similar conductive pusher pin. At least one of the first plurality of pusher pins 3812a-3812n (e.g., 3812a) and/or at least one of the second plurality of pusher pins 3820a-3820n has a portion made of or coated with an electrically insulative material corresponding to the pusher pins described herein, thus advantageously preventing shorting of the DUT. The pusher pins described below may also be utilized in the test assembly 3800.

The test assembly 3800 is configured to test the DUT. The DUT is illustrated in Figure 31 as an integrated circuit package 3813. The integrated circuit package 3813 includes a substrate 3817 on which one or more dies 3816a-3816n are mounted. The integrated circuit package 3813 may be configured to be pushed into the socket 3814 by the workpress 3806 under the influence of a force applied to the workpress 3806 by the actuator 3802. The integrated circuit package 3813 is clamped between the workpress 3806 and the socket 3814 while under test in the test assembly 3800. The test assembly 3800 may further include a test bed 3824 within which a test controller 3826 is electrically coupled to one or more of the pusher pins 3820a-3820n embedded within the socket 3814 that are electrically conductive so that the test controller 3826 may communicate with the integrated circuit package 3813.

In operation, the actuator 3802 is operated to apply a force to displace the workpress 3806 towards the chip package 3813 disposed in the socket 3814. In response, the workpress 3806 displaces the first plurality of pusher pins 3812a-3812n. The pusher pins 3812a-3812n may engage one or more of the dies 3816a-3816n located on the substrate 3817 and/or other portion(s) of the chip package 3813, which, in turn, applies the force over a first area of the one or more dies 3816a-3816n and/or other portion(s) of the chip package 3813 in contact with the pins 3812a-3812n. This force pushes the chip package 3813 into the socket 3814 to engage the second plurality of pusher pins 3820a-3820n in the socket 3814 overlying the test bed 3824. The test controller 3826 may then apply currents, voltages, and/or sensors (not shown) to test the dies 3816a-3816n through the pusher pins 3820a-3820n that are electrically conductive, or other electrical interconnect established between the package 3813 and socket 3814.

Figure 31A shows one example of an enlarged portion of the chip package 3813 in contact with the pusher pins 3812a-3812d. In the example depicted in Figure 31A, the pusher pin 3812a is illustrated contacting a top surface 840 of the substrate 3817, the pusher pin 3812b is illustrated contacting a surface mounted circuit component 3842 disposed on the top surface 840 of the substrate 3817, the pusher pin 3812c is illustrated contacting a stiffener 3844 disposed on the top surface 840 of the substrate 3817, and the pusher pin 3812d is illustrated contacting a top surface of the die 3816. The surface mounted circuit component 3842 may be a passive circuit component, such as resistors, capacitors, diodes, inductors and the like. Although the pusher pins 3812a-3812d are shown in contact with multiple features (i.e., the top surface 840 of the substrate 3817, the die 3816, the stiffener 3844, and the surface mounted circuit component 3842) of the chip package 3813, the pusher pins 3812 may be optionally limited to contact only one type of the features of the chip package 3813, to contact only two types of the features feature of the chip package 3813, to contact only three types of feature of the chip package 3813, or to contact any desired type(s) or combination of types of features of the chip package 3813. Returning back to Figure 31, the pusher pins 3812a-3812n, 3820a-3820n may apply the force over a larger area than beds of conventional pusher pins with small contact area tips as is found in the related art. Because the force is distributed over a larger area, reduced pressure is applied to the dies 3816a-3816n and the substrate 3817, thereby reducing the risk of die and/or package delamination and die and/or substrate cracks. Additionally, the pusher pins 3812a-3812n, 3820a-3820n that are electrically insulative may contact the integrated circuit package 3813 without reduced probability of shorting circuit exposed on the package 3813, thereby reducing the potential for damaging the package 3813 while in the test assembly 3800. Furthermore, as the pressure applied to the dies 3816a-3816n and the substrate 3817 by the pusher pins 3812a-3812n, 3820a-3820n is generally decoupled from mechanical manufacturing tolerances, the risk of potential damage the package 3813 while in the test assembly 3800 is much smaller as compared to conventional metal workpress solutions utilized in conventional test systems. TIM may still optionally be employed for additional force spreading and/or enhancing heat transfer to or from the DUT.

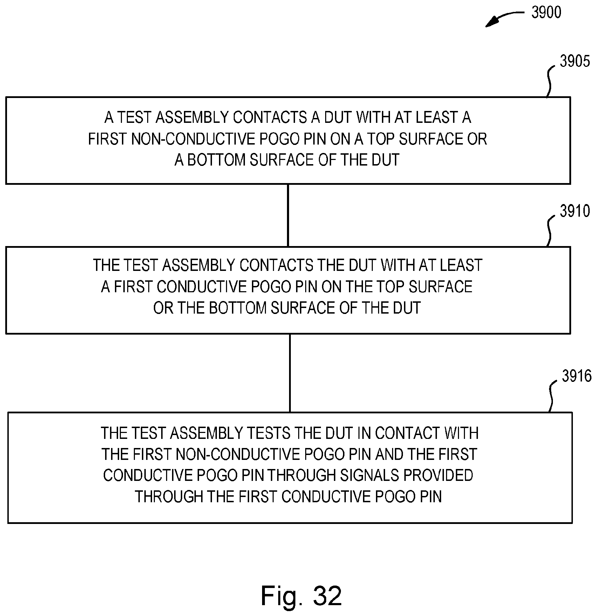

Figure 32 is a process flow of a method 3900 of testing an integrated circuit package in an integrated circuit package test assembly 3800, according to an embodiment. At block 3905, the test assembly 3800 contacts a DUT with at least a first non-conductive pusher pin on a top surface or a bottom surface of the DUT. At block 3910, the test assembly 3800 contacts the DUT with at least a first conductive pusher pin on the top surface or the bottom surface of the DUT. At block 3915, the test assembly 3800 tests the DUT in contact with the first non-conductive pusher pin and the first conductive pusher pin though signals provided through the first conductive pusher pin.

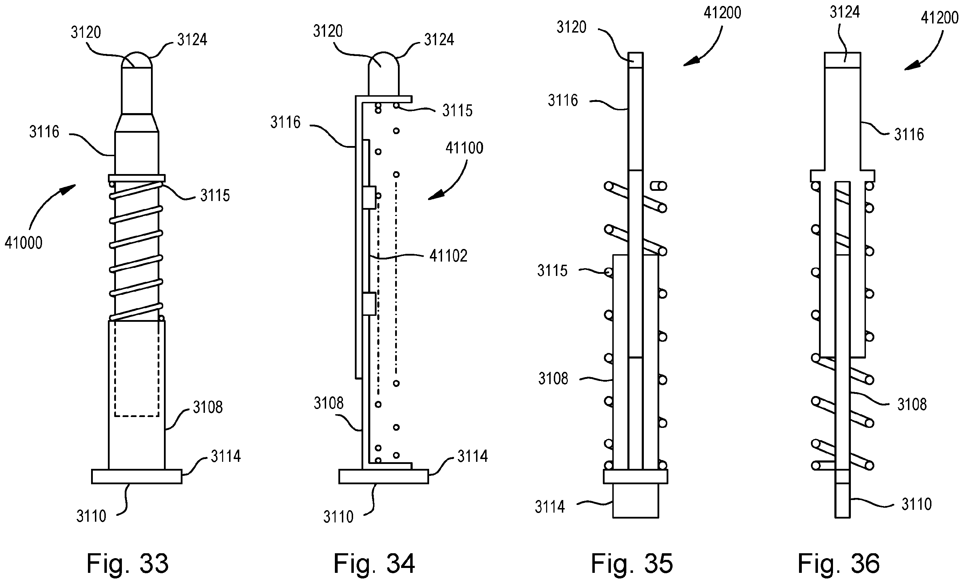

Figure 33 shows a side view of an exemplary pusher pin 41000 having an external spring 3115, according to an embodiment. The pusher pin 41000 is constructed similar to the pusher pins described above in reference to Figures 1-9, except wherein the spring 3115 is located outside of the plunger members 3108, 3116.

The pusher pin 41000 has an electrically insulative path defined between opposite ends 3110, 3120 of the pusher pin 41000. The electrically insulative path defined between the opposite ends 3110, 3120 of the pusher pin 41000 may be realized in any number of ways. For example, the second end 3110 of a first plunger member 3108 may include an electrically insulative tip 3114. In another example, a second end 3120 of a second plunger member 3108 may include an electrically insulative tip 3124. Alternatively, at least one of the first and second plunger members 3108, 3116 may be fabricated from or coated with an electrically insulative material, or include an electrically insulative portion that prevents electrical conduction between the opposite ends 3110, 3120 of the pusher pin 41000, such as described herein.

Figure 34 shows a side view of an exemplary pusher pin 41100 having a slide mechanism 41102 coupling the plunger members 3108, 3116 of the pusher pin 41100, according to an embodiment. The slide mechanism 41102 allows one plunger member, e.g., the plunger member 3108, to slide linearly relative to the other plunger member, e.g., the plunger member 3116. The slide mechanism 41102 may be configured as any suitable linear slide, such as one or more guides slideably mounted to a rail, that enables the plunger members 3108, 3116 to move relative to each other. A spring 3115 is coupled to the plunger members 3108, 3116 and biases the ends 3110, 3120 of the pin 41100 in opposite directions.

The plunger members 3108, 3116 may be fabricated from a stamped material, such as a metal, or be machined, casted, molded or otherwise formed. Alternatively, the plunger members 3108, 3116 may be extruded, molded or otherwise formed from a rigid plastic.

The pusher pin 41100 has an electrically insulative path defined between opposite ends 3110, 3120 of the pusher pin 41100. The electrically insulative path defined between the opposite ends 3110, 3120 of the pusher pin 41000 may be realized in any number of ways. For example, the second end 3110 of a first plunger member 3108 may include an electrically insulative tip 3114. In another example, a second end 3120 of a second plunger member 3108 may include an electrically insulative tip 3124. Alternatively, at least one of the first and second plunger members 3108, 3116 may be fabricated from or coated with an electrically insulative material, or include an electrically insulative portion that prevents electrical conduction between the opposite ends 3110, 3120 of the pusher pin 41100, such as described herein.

Figures 35-36 show side and front views of an exemplary pusher pin 41200 having an external spring 3115, according to an embodiment. The pusher pin 41200 is configured with first and second plunger members 3108, 3116 having an "H" configuration that guides the relative motion between the plunger members 3108, 3116. In the embodiment depicted in Figures 35-36, each plunger member 3108, 3116 has a flat form that is turned at an angle, such as 30-90 degrees, relative to the other plunger member 3108, 3116 so that the legs of the "H" configuration of each plunger member 3108, 3116 can engage with each other. The plunger members 3108, 3116 may be fabricated from stamped materials, such as metals or rigid plastic.

As with the other pins described above, the pusher pin 41200 has an electrically insulative path defined between opposite ends 3110, 3120 of the pusher pin 41200. The electrically insulative path defined between the opposite ends 3110, 3120 of the pusher pin 41000 may be realized in any number of ways. For example, the second end 3110 of a first plunger member 3108 may include an electrically insulative tip 3114. In another example, a second end 3120 of a second plunger member 3108 may include an electrically insulative tip 3124. Alternatively, at least one of the first and second plunger members 3108, 3116 may be fabricated from or coated with an electrically insulative material, or include an electrically insulative portion that prevents electrical conduction between the opposite ends 3110, 3120 of the pusher pin 41200, such as described herein.

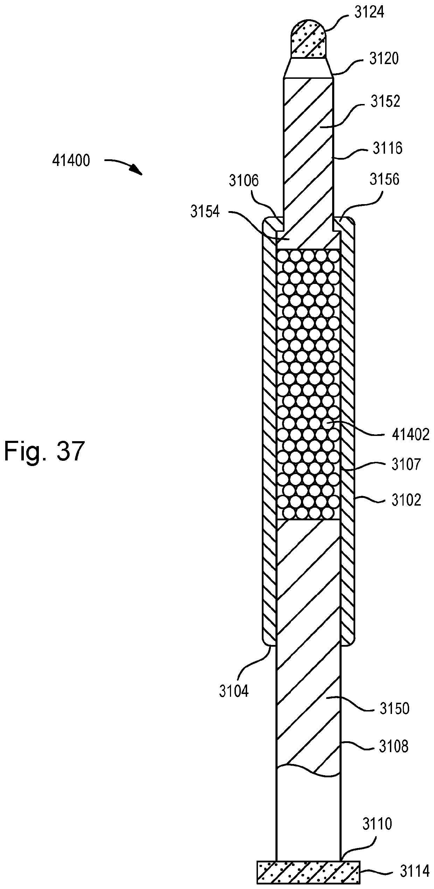

Figure 37 shows a sectional view of an exemplary pusher pin 41400 having a spring 41402 fabricated from a compressible, resilient material, according to an embodiment. The compressible, resilient material comprising the spring 41402 may be fabricated from foam, an elastomer or plastic spheres. The spring 41402 may be fabricated from electrically conductive or insulative material.

As with the other pins described above, the pusher pin 41400 has an electrically insulative path defined between opposite ends 3110, 3120 of the pusher pin 41400. The electrically insulative path defined between the opposite ends 3110, 3120 of the pusher pin 41000 may be realized in any number of ways. For example, the second end 3110 of a first plunger member 3108 may include an electrically insulative tip 3114. In another example, a second end 3120 of a second plunger member 3108 may include an electrically insulative tip 3124. Alternatively, at least one of the first and second plunger members 3108, 3116 may be fabricated from or coated with an electrically insulative material, or include an electrically insulative portion that prevents electrical conduction between the opposite ends 3110, 3120 of the pusher pin 41400, such as described herein.

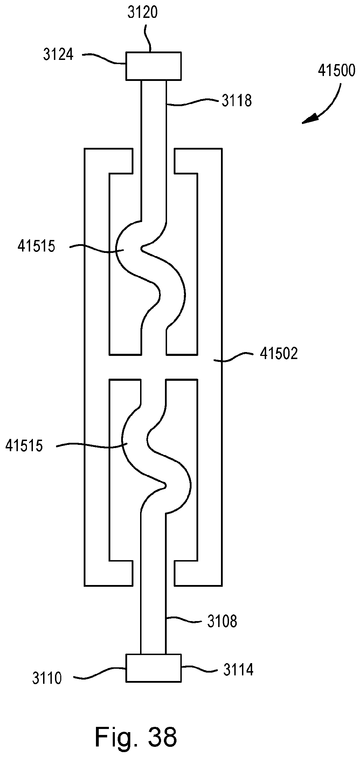

Figure 38 shows a side view of an exemplary pusher pin 41500 having a unitary construction that incorporates a spring form, according to an embodiment. That is, at least one spring 41515 and the plunger members 3108, 3116 are made from a single mass of material to provide the unitary construction. For example, the unitary construction may be achieved through stamping, machining, MEMS fabrication techniques, 3D printing or other suitable technique.

In the embodiment depicted in Figure 38, two springs 41515 are utilized which are coupled to a frame 41502 at one end. The opposite ends (e.g., ends 3110, 3120) of each spring 41515 are coupled to a respective one of the plunger members 3108, 3116. In one example, the springs 41515 are flat springs.

The frame 41502 laterally surrounds the plunger members 3108, 3116 and springs 41515 to provide a guide that orients the pusher pin 41500 within the receiving hole in which the pusher pin 41500 is formed. The ends 3110, 3120 extend axially through a gap in the frame 41502 a sufficient distance to allow a desired range of motion of the plunger members 3108, 3116 without the ends 3110, 3120 retracting within the bounds of the frame 41502.

As with the other pins described above, the pusher pin 41500 has an electrically insulative path defined between opposite ends 3110, 3120 of the pusher pin 41500. The electrically insulative path defined between the opposite ends 3110, 3120 of the pusher pin 41000 may be realized in any number of ways. For example, the second end 3110 of a first plunger member 3108 may include an electrically insulative tip 3114. In another example, a second end 3120 of a second plunger member 3108 may include an electrically insulative tip 3124. Alternatively, at least one of the first and second plunger members 3108, 3116, springs 41515 may be fabricated from or coated with an electrically insulative material, or include an electrically insulative portion that prevents electrical conduction between the opposite ends 3110, 3120 of the pusher pin 41500, such as described with reference to Figures 4-7. In yet another example, the portion of the frame 41502 separating the springs 41515 may be fabricated from or coated with an electrically insulative so as to provide an open circuit between the ends 3110, 3120 of the pusher pin 41500.

With all the pusher pins described above, the pusher pins are sized to allow a pitch between axially aligned pusher pins of 1.0 mm centerline to centerline pitch. In other examples, the centerline to centerline pitch may be as small as 0.4 mm. The end to end (i.e., between the ends 3110, 3120) range of motion (i.e., axial displacement) of the pusher pins may be in the range of 0.7 to 2.0 mm. The pusher pins may generate between 5.0 and 0.15 newtons of force.

Some of the implementations described herein may be expressed in the following non-limiting examples.

In a first example, the implementation described above can be expressed as a method for testing a chip package. The method includes moving a bottom surface of a workpress against a multi-planar top surface topography of a chip package assembly disposed in a socket of an automated test system; dynamically conforming the bottom surface of the workpress to the multi-planar top surface topography of the chip package assembly as the workpress moves towards the socket; and testing the chip package utilizing signals transmitted through the socket to the chip package assembly.

In a second example, testing in the method of the first example includes performing at least one of a DC test routine, a burn-in routine, post burn-in routine, or a final test routine.

In a third example, a method of testing an integrated circuit package in an integrated circuit package test assembly is provided that includes contacting a DUT with at least a first non-conductive pusher pin on a top surface or a bottom surface of the DUT; contacting the DUT with at least a first conductive pusher pin on the top surface or the bottom surface of the DUT; and testing the DUT in contact with the first non-conductive pusher pin and the first conductive pusher pin though signals provided through the first conductive pusher pin.

In a fourth example, a pusher pin is provided that includes: a first plunger member having a first end and an exposed second end; a second plunger member having a first end and an exposed second end, the second plunger member movable relative to the first plunger member, the exposed second ends of the first and second plunger members defining a length of the pusher pin; and a spring disposed between the first ends of the first and second plunger members, the spring biasing the exposed second end of the first plunger member away from the exposed second end of the second plunger member, wherein an electrically insulative path is defined between the exposed second end of the first plunger member and the exposed second end of the second plunger member through the pusher pin.

In a fifth example, the pusher pin of the fourth example further includes a shell having a cavity formed therein, wherein the second plunger member is partially captured in the cavity and the spring is disposed in the cavity.

In a sixth example, the pusher pin of the fifth example has at least a portion the shell made from or coated with an electrically insulative material that provides an open circuit between the exposed second ends of the first and second plunger members.

In a seventh example, the pusher pin of the third example has the exposed second end of the first plunger member further including an electrically insulative tip affixed thereto that provides an open circuit between the exposed second ends of the first and second plunger members.

In an eighth example, the pusher pin of the seventh example has a width of the electrically insulative tip that is wider than an axial diameter of the shell.

In a ninth example, the pusher pin of the seventh example has an electrically insulative tip located at a second end of the second plunger member that provides an open circuit between the exposed second ends of the first and second plunger members.

In a tenth example, the pusher pin of the third example has at least a portion of the first plunger member made of or coated with an electrically insulative material that provides an open circuit between the exposed second ends of the first and second plunger members.

In an eleventh example, the pusher pin of the third example has at least a portion of at least one of the first and second plunger members made of or coated with an electrically insulative material that provides an open circuit between the exposed second ends of the first and second plunger members.

In a twelfth example, the pusher pin of the third example has the spring made of an electrically non-conductive material that provides an open circuit between the exposed second ends of the first and second plunger members.

In a thirteenth example, an integrated circuit package test assembly is provided that includes: a workpress having a top end and a bottom end, the bottom end having a first plurality of pusher pins; a socket having a top end facing the bottom end of the workpress, the top end of the socket having a second plurality of pusher pins; and an actuator configured to move the workpress towards the socket a sufficient distance to cause the first plurality of pins and the second plurality of pins to engage a DUT when disposed in the socket; wherein at least a first pusher pin of the first plurality of pusher pins or at least one pusher pin of the second plurality of pusher pins has an open circuit defined between opposite ends of the first pusher pin.

In a fourteenth example, the first pusher pin of the assembly of the thirteenth example includes: a first plunger member having a first end and an exposed second end; a second plunger member having a first end and an exposed second end, the second plunger member movable relative to the first plunger member, the exposed second ends of the first and second plunger members defining a length of the pusher pin; and a spring disposed between the first ends of the first and second plunger members, the spring biasing the exposed second end of the first plunger member away from the exposed second end of the second plunger member, wherein open circuit is defined between the exposed second end of the first plunger member and the exposed second end of the second plunger member through the pusher pin.

In a fifteenth example, the assembly of the thirteenth example includes a shell having a cavity formed therein, wherein the second plunger member is partially captured in the cavity and the spring is disposed in the cavity.

In a sixteenth example, the assembly of the fifteenth example has at least a portion the shell made from or coated with an electrically insulative material that provides the open circuit between the exposed second ends of the first and second plunger members.

In a seventeenth example, the assembly of the thirteenth example has the exposed second end of the first plunger member further including an electrically insulative tip affixed thereto that provides the open circuit between the exposed second ends of the first and second plunger members.

In an eighteenth example, the assembly of the seventeenth example has a width of the electrically insulative tip that is wider than an axial diameter of the shell.

In an nineteenth example, the assembly of the seventeenth example has the exposed second end of the second plunger member that further includes an electrically insulative tip affixed thereto that provides the open circuit between the exposed second ends of the first and second plunger members.

In a twentieth example, the assembly of the seventeenth example has at least a portion of the first plunger member made of or coated with an electrically insulative material that provides the open circuit between the exposed second ends of the first and second plunger members.

In a twenty-first example, the assembly of the seventeenth example has at least a portion of at least one of the first and second plunger members is made of or coated with an electrically insulative material that provides an open circuit between the exposed second ends of the first and second plunger members.

In twenty-second example, the assembly of the seventeenth example has the spring made of or coated with an electrically non-conductive material that provides the open circuit between the exposed second ends of the first and second plunger members.

Thus, a chip package assembly test system and method for testing a chip package assembly has been provided which improves testing by enabling testing of testing chip package assemblies with reduced probability to damage due to excessive force being applied to the chip package assembly by the workpress. In particular, the bottom surface of the workpress is configured to dynamically conform to the varied topography of the chip package assembly under test, thus more effectively controlling and distributing the force applied to the chip package assembly as compared to conventional test systems with metal workpresses. The use of non-conductive pusher pins and light loads allow force to be applied to regions of the chip package assembly that would be susceptive to damage and/or shorting in conventional test systems, thus providing a more robust and reliable test connections. Furthermore, the dynamically conforming bottom surface of the workpress enables a wider range of chip package assemblies to be tested utilizing the same workpress, thus improving the capacity (e.g., throughput) of the test system by minimizing down time for workpress exchange while reducing the cost of ownership.

While the foregoing is directed to embodiments of the present disclosure, other and further embodiments of the disclosure may be devised without departing from the basic scope thereof, and the scope thereof is determined by the claims that follow.

## Claims

1. An integrated circuit chip package test system (100) comprising:
a socket (120) having a recess (122) configured to receive a chip package assembly (160) for testing; and
a workpress (106) positioned over the socket (120), the workpress having a plurality of non-conductive pusher pins (118) that are electrically discontinuous tip to tip, each non-conductive pusher pin of the plurality of non-conductive pusher pins (118) extending from a bottom surface (116) of the workpress (106), the plurality of non-conductive pusher pins being dynamically conformable to a multi- planar top surface topography of the chip package assembly (160), the plurality of non-conductive pusher pins of the workpress (106) being arranged to contact the chip package assembly disposed in the recess (122), the plurality of non-conductive pusher pins comprising:
a first pusher pin having a first spring constant and a first length, the first pusher pin configured to generate a first force when the plurality of non-conductive pusher pins contacts the chip package assembly (160) disposed in the recess (122); and
a second pusher pin having a second spring constant and a second length, the second pusher pin configured to generate a second force when the plurality of non-conductive pusher pins contacts the chip package assembly (160) disposed in the recess (122), wherein at least one of the first spring constant and the first length is different than the second spring constant and the second length and the first force is different than the second force.

2. The integrated circuit chip package test system of claim 1, wherein the workpress (106) further comprises:
at least one conductive pusher pin (1018) configured to permit high speed signal transmission therethrough, the conductive pusher pin having a tip extending from the bottom surface of the workpress.

3. The integrated circuit chip package test system of claim 1 further comprising:
a sheet of compliant material disposed below the tips of the plurality of non-conductive pusher pins (118) and configured to distribute force generated by the plurality of non-conductive pusher pins across the multi-planar top surface topography of the chip package assembly (160).

4. The integrated circuit chip package test system of claim 1, wherein the tip of at least one pusher pin of the plurality of non-conductive pusher pins is fabricated from a dielectric material.

5. The integrated circuit chip package test system of claim 1 further comprising:
a plurality of pusher pin holes (202), wherein at least one or more of the pusher pin holes does not contain one of the plurality of non-conductive pusher pins (118) disposed therein, and wherein at least one or more of the pusher pin holes has a respective one of the plurality of non-conductive pusher pins disposed therein.

6. The integrated circuit chip package test system of claim 1 further comprising:
a plurality of pusher pin holes (202) each having a respective one of the plurality of non-conductive pusher pins (118) disposed therein; and
a depleted area (310) devoid of pusher pin holes defined within a boundary defined by an area of the bottom surface (116) of the workpress (106) in which the plurality of pusher pin holes are formed, the depleted area being the size of at least one pusher pin hole.

7. The integrated circuit chip package test system of claim 1, wherein the plurality of non-conductive pusher pins (118) have a uniform pitch in at least one direction.

8. The integrated circuit chip package test system of claim 1, wherein the plurality of non-conductive pusher pins (118) further comprise:
a first group of pusher pins having a first pitch in a first direction; and
a second group of pusher pins having a second pitch in the first direction that is different than the first pitch.

9. The integrated circuit chip package test system of claim 1, wherein the plurality of non-conductive pusher pins further comprise:
a first group of pusher pins having a first size; and
a second group of pusher pins having a second size that is different than the first size.

10. The integrated circuit chip package test system of claim 1, wherein pusher pin holes (202) containing the first pusher pin and the second pusher pin have a common depth.

11. The integrated circuit chip package test system of claim 1, wherein at least one pusher pin hole of pusher pin holes containing the first pusher pin and the second pusher pin has a spacer (814) disposed therein.

12. The integrated circuit chip package test system of claim 1, wherein pusher pin holes containing the first pusher pin and the second pusher pin have a different depth.

## Patentansprüche

1. Testsystem (100) für integrierte Schaltkreis-Chip-Pakete, umfassend:
einen Sockel (120), der eine Aussparung (122) aufweist, die konfiguriert ist, um eine Chip-Paket-Anordnung (160) zum Testen aufzunehmen; und
eine Arbeitspresse (106), die über dem Sockel (120) positioniert ist, wobei die Arbeitspresse eine Vielzahl von nicht-leitenden Drückerstiften (118) aufweist, die von Spitze zu Spitze elektrisch unterbrochen sind, wobei sich jeder nichtleitende Drückerstift aus der Vielzahl von nicht-leitenden Drückerstiften (118) von einer unteren Oberfläche (116) der Arbeitspresse (106) erstreckt, wobei die Vielzahl von nicht-leitenden Drückerstiften an eine multiplanare Topographie einer oberen Oberfläche der Chip-Paket-Anordnung (160) dynamisch anpassbar ist, wobei die Vielzahl von nicht-leitenden Drückerstiften der Arbeitspresse (106) arrangiert ist, um die Chip-Paket-Anordnung zu berühren, die in der Aussparung (122) eingerichtet ist, die Vielzahl von nicht-leitenden Drückerstiften umfassend:
einen ersten Drückerstift, der eine erste Federkonstante und eine erste Länge aufweist, wobei der erste Drückerstift konfiguriert ist, um eine erste Kraft zu erzeugen, wenn die Vielzahl von nicht-leitenden Drückerstiften die Chip-Paket-Anordnung (160) berührt, die in der Aussparung (122) eingerichtet ist; und
einen zweiten Drückerstift, der eine zweite Federkonstante und eine zweite Länge aufweist, wobei der zweite Drückerstift konfiguriert ist, um eine zweite Kraft zu erzeugen, wenn die Vielzahl von nicht-leitenden Drückerstiften die Chip-Paket-Anordnung (160) berührt, die in der Aussparung (122) eingerichtet ist, wobei sich mindestens eine der ersten Federkonstante und der ersten Länge von der zweiten Federkonstante und der zweiten Länge unterscheiden und die erste Kraft sich von der zweiten Kraft unterscheidet.

2. Testsystem für integrierte Schaltkreis-Chip-Pakete nach Anspruch 1, wobei die Arbeitspresse (106) ferner umfasst:
mindestens einen leitfähigen Drückerstift (1018), der konfiguriert ist, um eine Hochgeschwindigkeitssignalübertragung dahindurch zu ermöglichen, wobei der leitfähige Drückerstift eine Spitze aufweist, die sich von der unteren Oberfläche der Arbeitspresse erstreckt.

3. Testsystem für integrierte Schaltkreis-Chip-Pakete nach Anspruch 1, ferner umfassend:
eine Schicht aus nachgiebigem Material, die unter den Spitzen der Vielzahl von nicht-leitenden Drückerstiften (118) eingerichtet und konfiguriert ist, um die Kraft, die durch die Vielzahl von nicht-leitenden Drückerstiften erzeugt wird, über die multiplanare Topographie der oberen Oberfläche der Chip-Paket-Anordnung (160) zu verteilen.

4. Testsystem für integrierte Schaltkreis-Chip-Pakete nach Anspruch 1, wobei die Spitze von mindestens einem Drückerstift aus der Vielzahl von nicht-leitenden Drückerstiften aus einem dielektrischen Material hergestellt ist.

5. Testsystem für integrierte Schaltkreis-Chip-Pakete nach Anspruch 1, ferner umfassend:
eine Vielzahl von Drückerstiftlöchern (202), wobei mindestens eines oder mehrere der Drückerstiftlöcher keines der Vielzahl von nicht-leitenden Drückerstiften (118) enthalten, die darin eingerichtet ist, und wobei mindestens eines oder mehrere der Drückerstiftlöcher ein jeweiliges eines der Vielzahl von nicht-leitenden Drückerstiften darin eingerichtet aufweist.

6. Testsystem für integrierte Schaltkreis-Chip-Pakete nach Anspruch 1, ferner umfassend:
eine Vielzahl von Drückerstiftlöchern (202), die ein jeweiliges eines der Vielzahl von nicht-leitenden Drückerstiften (118) darin eingerichtet aufweist, und
einen verarmten Bereich (310) ohne Drückerstiftlöcher, der innerhalb einer Grenze definiert ist, die durch einen Bereich der unteren Oberfläche (116) der Arbeitspresse (106) definiert ist, in dem die Vielzahl von Drückerstiftlöchern ausgebildet wird, wobei der verarmte Bereich die Größe von mindestens einem Drückerstiftloch hat.

7. Testsystem für integrierte Schaltkreis-Chip-Pakete nach Anspruch 1, wobei die Vielzahl von nicht-leitenden Drückerstiften (118) in mindestens einer Richtung einen gleichmäßigen Zwischenraum aufweist.

8. Testsystem für integrierte Schaltkreis-Chip-Pakete nach Anspruch 1, wobei die Vielzahl von nicht-leitenden Drückerstiften (118) ferner umfasst:
eine erste Gruppe von Drückerstiften, die einen ersten Zwischenraum in einer ersten Richtung aufweist; und
eine zweite Gruppe von Drückerstiften, die einen zweiten Zwischenraum in der ersten Richtung aufweist, der sich von dem ersten Zwischenraum unterscheidet.

9. Testsystem für integrierte Schaltkreis-Chip-Pakete nach Anspruch 1, wobei die Vielzahl von nicht-leitenden Drückerstiften ferner umfasst:
eine erste Gruppe von Drückerstiften, die eine erste Größe aufweist; und
eine zweite Gruppe von Drückerstiften, die eine zweite Größe aufweist, die sich von der ersten Größe unterscheidet.

10. Testsystem für integrierte Schaltkreis-Chip-Pakete nach Anspruch 1, wobei die Drückerstiftlöcher (202), die den ersten Drückerstift und den zweiten Drückerstift enthalten, eine gemeinsame Tiefe aufweisen.

11. Testsystem für integrierte Schaltkreis-Chip-Pakete nach Anspruch 1, wobei mindestens ein Drückerstiftloch der Drückerstiftlöcher den ersten Drückerstift enthält, und der zweite Drückerstift einen Abstandshalter (814) darin eingerichtet aufweist.

12. Testsystem für integrierte Schaltkreis-Chip-Pakete nach Anspruch 1, wobei die Drückerstiftlöcher, die den ersten Drückerstift und den zweiten Drückerstift enthalten, eine unterschiedliche Tiefe aufweisen.

## Revendications

1. Système de test de boîtier de puce de circuit intégré (100) comprenant :
une douille (120) ayant un évidement (122) conçu pour recevoir un ensemble boîtier de puce (160) aux fins de test ; et
une presse de travail (106) positionnée sur la douille (120), la presse de travail ayant une pluralité de broches de poussée non conductrices (118) qui sont électriquement discontinues d'une pointe à l'autre, chaque broche de poussée non conductrice de la pluralité de broches de poussée non conductrices (118) s'étendant à partir d'une surface inférieure (116) de la presse de travail (106), la pluralité de broches de poussée non conductrices étant dynamiquement conformables à une topographie de surface supérieure multiplanaire de l'ensemble boîtier de puce (160), la pluralité de broches de poussée non conductrices de la presse de travail (106) étant agencées pour entrer en contact avec l'ensemble boîtier de puce disposé dans l'évidement (122), la pluralité de broches de poussée non conductrices comprenant :
une première broche de poussée ayant une première constante de ressort et une première longueur, la première broche de poussée étant conçue pour générer une première force lorsque la pluralité de broches de poussée non conductrices entrent en contact avec l'ensemble boîtier de puce (160) disposé dans l'évidement (122) ; et
une seconde broche de poussée ayant une seconde constante de ressort et une seconde longueur, la seconde broche de poussée étant conçue pour générer une seconde force lorsque la pluralité de broches de poussée non conductrices entrent en contact avec l'ensemble boîtier de puce (160) disposé dans l'évidement (122), dans lequel au moins l'une parmi la première constante de ressort et la première longueur est différente de la seconde constante de ressort et de la seconde longueur, et la première force est différente de la seconde force.

2. Système de test de boîtier de puce de circuit intégré selon la revendication 1, dans lequel la presse de travail (106) comprend en outre :
au moins une broche de poussée conductrice (1018) conçue pour permettre la transmission de signaux à grande vitesse à travers celle-ci, la broche de poussée conductrice ayant une pointe s'étendant à partir de la surface inférieure de la presse de travail.

3. Système de test de boîtier de puce de circuit intégré selon la revendication 1, comprenant en outre :
une feuille de matériau souple disposée sous les pointes de la pluralité de broches de poussée non conductrices (118) et conçue pour répartir la force générée par la pluralité de broches de poussée non conductrices sur la topographie de la surface supérieure multiplanaire de l'ensemble boîtier de puce (160).

4. Système de test de boîtier de puce de circuit intégré selon la revendication 1, dans lequel la pointe d'au moins une broche de poussée parmi la pluralité de broches de poussée non conductrices est fabriquée à partir d'un matériau diélectrique.

5. Système de test de boîtier de puce de circuit intégré selon la revendication 1, comprenant en outre :
une pluralité de trous de broches de poussée (202), dans lequel au moins un ou plusieurs parmi les trous de broches de poussée ne contiennent pas une broche de poussée parmi la pluralité de broches de poussée non conductrices (118) disposées à l'intérieur de ceux-ci, et dans lequel au moins un ou plusieurs parmi les trous de broches de poussée contiennent une broche de poussée respective parmi la pluralité de broches de poussée non conductrices disposées à l'intérieur de ceux-ci.

6. Système de test de boîtier de puce de circuit intégré selon la revendication 1, comprenant en outre :
une pluralité de trous de broches de poussée (202) contenant chacun une broche de poussée respective parmi la pluralité de broches de poussée non conductrice (118) à l'intérieur de ceux-ci ; et
une zone épuisée (310) dépourvue de trous de broches de poussée définie à l'intérieur d'une limite définie par une zone de la surface inférieure (116) de la presse de travail (106) dans laquelle la pluralité de trous de broches de poussée sont formés, la zone épuisée ayant la taille d'au moins un trou de broche de poussée.

7. Système de test de boîtier de puce de circuit intégré selon la revendication 1, dans lequel la pluralité de broches de poussée non conductrices (118) ont un pas uniforme dans au moins une direction.

8. Système de test de boîtier de puce de circuit intégré selon la revendication 1, dans lequel la pluralité de broches de poussée non conductrices (118) comprennent en outre :
un premier groupe de broches de poussée ayant un premier pas dans une première direction ; et
un second groupe de broches de poussée ayant un second pas dans la première direction qui est différent du premier pas.

9. Système de test de boîtier de puce de circuit intégré selon la revendication 1, dans lequel la pluralité de broches de poussée non conductrices comprennent en outre :
un premier groupe de broches de poussée ayant une première taille ; et
un second groupe de broches de poussée ayant une seconde taille différente de la première taille.

10. Système de test de boîtier de puce de circuit intégré selon la revendication 1, dans lequel les trous de broches de poussée (202) contenant la première broche de poussée et la seconde broche de poussée ont une profondeur commune.

11. Système de test de boîtier de puce de circuit intégré selon la revendication 1, dans lequel au moins un trou de broche de poussée parmi les trous de broches de poussée contenant la première broche de poussée et la seconde broche de poussée a une entretoise (814) disposée à l'intérieur de celui-ci.

12. Système de test de boîtier de puce de circuit intégré selon la revendication 1, dans lequel des trous de broche de poussée contenant la première broche de poussée et la seconde broche de poussée ont une profondeur différente.
